# EUROPEAN PATENT SPECIFICATION

(11) **EP 3 540 738 B1**
(45) Date of publication and mention of the grant of the patent: **30.12.2020**
(21) Application number: 18000262.8
(22) Date of filing: 15.03.2018
(51) Int. Cl.: G11C 14/00, G06F 9/30, G11C 11/16

(54) **MULTI-BIT NON-VOLATILE FLIP-FLOP**
NICHTFLÜCHTIGER MULTI-BIT-FLIP-FLOP
BASCULE BISTABLE NON VOLATILE MULTI-BITS

(43) Date of publication of application: 18.09.2019
(73) Proprietor: Karlsruher Institut für Technologie, 76131 Karlsruhe (DE)
(72) Inventor: Bishnoi, Rajendra, 76676 Graben-Neudorf (DE); Tahoori, Mehdi, 76139 Karlsruhe (DE); Münch, Christopher, 69207 Sandhausen (DE)
(74) Representative: Müller-Boré & Partner Patentanwälte PartG mbB

(56) References cited:
- WO-A1-2012/171988
- US-A1- 2017 131 910
- MUNCH CHRISTOPHER ET AL: "Multi-bit non-volatile spintronic flip-flop", 2018 DESIGN, AUTOMATION & TEST IN EUROPE CONFERENCE & EXHIBITION (DATE), EDAA, 19 March 2018 (2018-03-19), pages 1229-1234, XP033334047, DOI: 10.23919/DATE.2018.8342203 [retrieved on 2018-04-19]

## Description

### Technical Field

The following description relates to a flip-flop circuit enabling power gating that optimizes area and energy consumption.

### Background

Flip-flop circuits (hereinafter also "flip-flops") are used as storage elements to drive the inputs and capture the outputs of digital integrated circuits used in microprocessors. The current technology for integrated circuits is based on complementary metal-oxide-semiconductor (CMOS), which are characterized by low static power consumption. However, there is an increasing demand for a greater power efficiency.

Indeed, the microprocessors found in electronic devices consume power also when no operation is being performed, e.g. during sleep mode. The reason is that static power is consumed via leakage currents and the smaller the size of the transistors, the more significant the static power consumption. Therefore, as CMOS technology (i.e. transistor sizes) keeps scaling down, it becomes important to reduce the leakage currents, especially for low-power applications such as battery-operated portable devices. The easiest way to reduce leakage dissipation during sleep mode is to turn off the power supply to the sleeping circuits and this technique is called power gating. Power gating introduces a shift from always-on towards normally-off/instant-on computing.

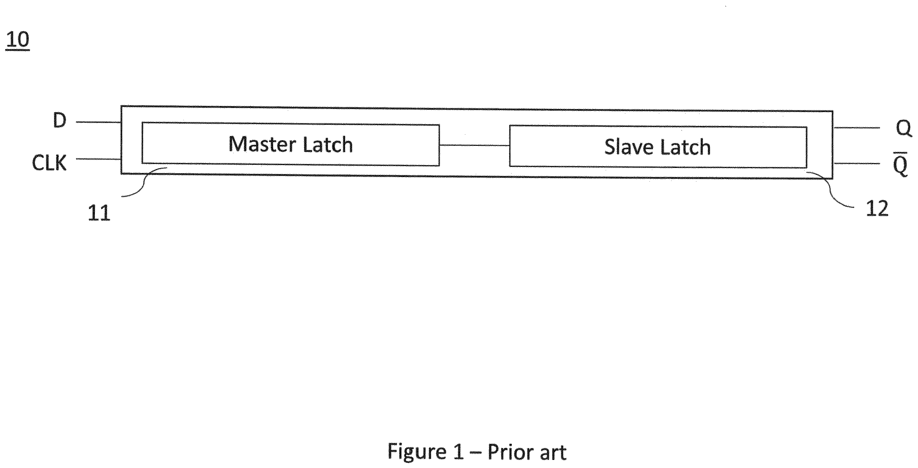

Unfortunately, conventional flip-flops provide a volatile memory, i.e. the information stored therein is lost when the power supply is interrupted. A conventional flip-flop 10 may be formed by combining a master latch 11 and a slave latch 12 in sequence, as shown in the schematic representation of **Figure 1****.** The flip-flop 10 captures the value of the input data D at a definite portion (e.g. rising edge) of the clock signal CLK and outputs the captured value at Q (and its opposite at Q̅).

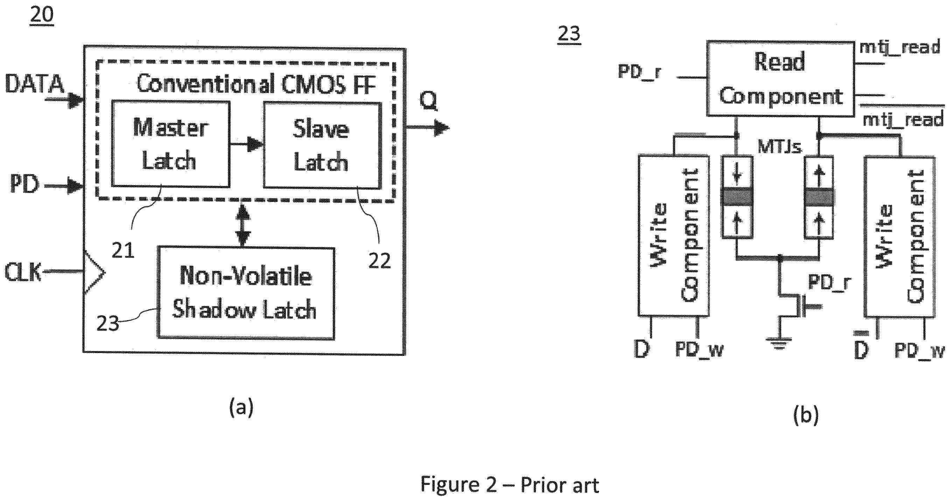

In order to perform power gating while retaining the state of the circuits, non-volatile solutions for flip-flops have been investigated. **Figure 2a** shows the schematic representation of a non-volatile flip-flop 20 according to the state of art. In comparison to the volatile flip-flop of Figure 1, the latches of the non-volatile flip-flop 20 include a non-volatile shadow latch 23 that is employed to back up data during sleep periods. Accordingly, the non-volatile flip-flop 20 may be denoted as non-volatile backup flip-flop or non-volatile shadow flip-flop. During a sleep period, before power gating (i.e. interrupting the power supply), the data are copied into the non-volatile shadow latch 23. Then, during wake-up (i.e. after resuming the power supply) the data are restored into the conventional flip-flop.

An emerging technology used for the non-volatile shadow latch 23 is the Spin Transfer Torque (STT), which is well known for its zero-leakage storage capability. In addition to the leakage reduction, this technology also has many other beneficial features such as scalability, high endurance, small footprint, CMOS compatibility, fast accessibility and immunity to soft-error due to radiations. In STT technology, a magnetic tunnel junction (MTJ) cell is the storing device. **Figure 2b** shows an exemplary non-volatile shadow latch 23, comprising a read component, a write component and two MTJ cells.

As explained, in the arrangement of Figures 2a and 2b the logic design block can be completely powered-off during the standby mode, thus reducing leakage considerably. The data from the conventional flip-flop is stored in the non-volatile shadow latch 23 during the power-down mode, and restored back during the power-up mode of operation. These store and restore operations are controlled by a power-down (PD) pin, that is activated/deactivated at system level based on the application.

However, the shadow component in the non-volatile flip-flop 20 occupies significant area and consumes a great amount of energy itself. In systems on chip (SoCs), typically many flip-flops are placed adjacent (or close) to each other in the layout. For static power reduction, each of such flip-flops has to be associated with a non-volatile component individually, leading to an overly designed architecture. Overall, a cost effective non-volatile flip-flop architecture providing a high area and energy efficiency is missing.

Document US 2017/131910 A1 discloses a register including: a plurality of volatile memory cells each having a first input and an output, the volatile memory cells being coupled in series with each other via their first inputs and outputs; a non-volatile memory comprising a plurality of non-volatile memory cells; and one or more serial connections adapted to perform at least one of: serially supply data to be written to the non-volatile memory from a last or another of the volatile memory cells to the non-volatile memory during a back-up operation of data stored by the volatile memory cells; and serially supply data read from the non-volatile memory to a first of the volatile memory cells during a restoration operation of the data stored by the volatile memory cells. This document discloses a non-volatile storage circuit for storing first data from a first flip-flop circuit and second data from a second flip-flop circuit when power gating, the non-volatile storage circuit comprising:
- a write component;
- two output nodes;
- a read component; and
- a first pair of non-volatile memories and a second pair of non-volatile memories connected to the read component and to the write component; wherein the non-volatile storage circuit is connectable to the first flip-flop circuit and the second flip-flop circuit; at power-down of the first flip-flop circuit and the second flip-flop circuit, the write component is configured to simultaneously write the first data to the first pair of non-volatile memories and the second data to the second pair of non-volatile memories; and at power-up of the first flip-flop circuit and the second flip-flop circuit, the read component is configured to sequentially read the first data from the first pair of non-volatile memories and the second data from the second pair of non-volatile memories. Reading the first data from the first pair of non-volatile memories being a first reading and reading the second data from the second pair of non-volatile memories being a second reading, the non-volatile storage circuit is configured such that during the second reading, the second pair of non-volatile memories is connected to a supply voltage source. The read component further comprises a sense amplifier including a first inverter and a second inverter, wherein each output node is connected to an output of a corresponding inverter.

Document WO 2012/171988 A1 discloses a memory device comprising at least one memory cell comprising: first and second pairs of cross-coupled transistors; and a first resistance switching element coupled between a first supply voltage and a first transistor of said first pair of transistors and programmed to have one of first and second resistances; and control circuitry adapted to store a data value at said first and second storage nodes by coupling said first storage node to said second supply voltage, the data value being determined by the programmed resistance of the first resistance switching element. This document discloses a non-volatile storage circuit for storing first data, the non-volatile storage circuit comprising:
- a write component;
- two output nodes;
- a read component comprising a pre-charge component connected to the two output nodes;and
- a first pair of non-volatile memories and a second pair of non-volatile memories connected to the read component and to the write component. The write component is configured to simultaneously write the first data to the first pair of non-volatile memories and the second data to the second pair of non-volatile memories. The read component is configured to sequentially read the first data from the first pair of non-volatile memories and the second data from the second pair of non-volatile memories. Reading the first data from the first pair of non-volatile memories is a first reading and reading the second data from the second pair of non-volatile memories is a second reading. The pre-charge component is configured to equalize the two output nodes at supply voltage during the first reading and at ground voltage during the second reading and the non-volatile storage circuit is configured such that the first pair of non-volatile memories is connected to ground during the first reading and the second pair of non-volatile memories is connected to a supply voltage source during the second reading. The read component further comprises a sense amplifier.

### Summary

It is an object of the invention to provide a non-volatile flip-flop that is optimized in terms of area and energy consumption.

The achievement of this object in accordance with the invention is set out in the independent claims. Further developments of the invention are the subject matter of the dependent claims.

The non-volatile storage circuit of the invention may also be referred to as "multi-bit non-volatile shadow latch", since its function is similar to that of the non-volatile shadow latch of the prior art, namely storing data *ad interim* when power supply is suspended. However, unlike a conventional non-volatile shadow latch, which holds data for a single flip-flop circuit, the multi-bit non-volatile shadow latch is configured to be shared among two or more flip-flop circuits, as explained below.

Indeed, each flip-flop circuit can store a single bit of data. A bit is a unit of data that can have only one of the two values of a binary state, which are also referred to as "complementary values". Usually these values are denoted with 0 and 1: 0 is the complementary value of 1 and 1 is the complementary value of 0. Therefore, a bit value can be either 0 or 1 and, respectively, the complementary bit value will be 1 or 0. The bit value alone already carries all the data information, however exemplarily both the bit value and the complementary bit value may be used to represent the information. For example, a volatile memory such as a flip-flop circuit may receive the information consisting of one bit having one of a bit value and a complementary bit value and store the information as data comprising both the bit value and the complementary bit value. In the following, "data" will denote a bit value together with its complementary value. Accordingly, "reading/writing data", "storing data" and "transmitting/receiving data" to/from volatile or non-volatile memories means that both the bit value (e.g. 0 or 1) and the complementary bit value are read, written, stored, transmitted or received, respectively.

Therefore, a conventional non-volatile shadow latch is a single-bit non-volatile shadow latch, whereas the non-volatile shadow latch of the present invention can store a plurality of bits, i.e. two or more bits.

In particular, the non-volatile storage circuit may be configured to be connected to a first flip-flop circuit and a second flip-flop circuit, in the sense that data can be transmitted to and from the non-volatile storage circuit to the flip-flop circuits. In other words, electrical currents can flow between the non-volatile storage circuit and each of the flip-flop circuits. The non-volatile storage circuit may store first data of the first flip-flop circuit and second data of the second flip-flop circuit, as explained below.

The non-volatile storage circuit comprises a first pair of non-volatile memories and a second pair of non-volatile memories. A non-volatile memory retains the stored information even in the absence of a power supply. Different technologies may provide a non-volatile memory suitable for the object of the invention. These technologies may include, but are not limited to, ferroelectric capacitors, phase-changing capacitor-like structures and magnet tunnel junctions. In the following, the non-volatile memories are also referred to as "non-volatile memory cells" or "non-volatile storage cells", since each one stores one bit of binary information. In particular, a non-volatile memory may be a storage element capable of storing a bit value (e.g. either a 0 or a 1). For example, the state of the non-volatile memory may be a binary state, such as a physical state of conductivity or non-conductivity. If the non-volatile memory is in a conducive state, it may represent and, thus, store a 1 and if the non-volatile memory is in a non-conducive state, it may represent and, thus, store a 0, or vice versa.

A pair of non-volatile memories may store collectively both the bit value and the complementary bit value, in that a first non-volatile memory may store the bit value and a second non-volatile memory may store the complementary bit value, or vice versa.

The non-volatile storage circuit comprises two pairs of non-volatile memories in order to store two bits, one from each flip-flop circuit. Specifically, the first pair of non-volatile memories may be configured to store first data, i.e. bit information in the form of a bit value and its complementary value, for the first flip-flop circuit, and the second pair of non-volatile memories may be configured to store second data, i.e. bit information in the form of a bit value and its complementary value, for the second flip-flop circuit.

The non-volatile storage circuit further comprises a write component connected to the first pair of non-volatile memories and to the second pair of non-volatile memories. The write component is configured to simultaneously write the first data to the first pair of non-volatile memories and the second data to the second pair of non-volatile memories. Accordingly, the write component may be connected to the first flip-flop circuit and the second flip-flop circuit and may be configured to receive the first data and the second data therefrom.

The write component may receive at least three input signals: two data signals and a write enable signal as control signal. Input signals are signals that are received as input by a circuit or a part thereof and may comprise both data signals, carrying information, and control signals, which regulate the behavior of the circuit or parts thereof.

Each input signal may be a digital signal, i.e. a signal that can be in a high state or a low state. A bit value is used to denote the logic level, i.e. the state, of the digital signal, wherein a logic level is usually represented by the voltage level of the signal, i.e. the difference between the signal voltage and the reference ground voltage.

Accordingly, setting the signal to the high state means applying a given voltage, e.g. a voltage approximately equal to the supply voltage or a voltage above a threshold percentage of the supply voltage, such as above about 85%, about 90% or about 95% of the supply voltage. Instead the low state corresponds to a voltage at about the reference point of 0 V, e.g. below a threshold percentage of the supply voltage, such as below about 5%, about 10% or about 15% of the supply voltage. Exemplarily, the high state or high logic level may be denoted with a '1' and the low state or low logic level may be denoted with a '0'. According to how the logic of a circuit element (e.g. a transistor or a transmission gate) is built, the circuit element may be active low, i.e. turned on by a low state signal, or active high, i.e. turned on by a high state signal.

An active signal is in the high state and an inactive signal is in the low state. A signal may be activated when it goes from low state to high state and deactivated when it goes from high state to low state. When operations are described in the following with reference to given logic levels of a signal, it is understood that the choice of the logic level is arbitrary and the same principles apply for both choices.

The write component may receive a first data signal carrying the first data from the first flip-flop circuit and a second data signal carrying the second data from the second flip-flop circuit. When the write enable signal is activated, the data in the data signals may be "forwarded" to the non-volatile memories. Exemplarily, the write component may perform a write operation (also referred to as "store operation") by making an electrical current flow in and/or by applying a voltage to the non-volatile memories. The phase during which the write component stores the first data and the second data in the first pair of non-volatile memories and the second pair of non-volatile memories, respectively, may be called "write phase" or "store phase".

The write phase is triggered when power supply is about to be interrupted for the first flip-flop circuit and the second flip-flop circuit. In particular, a digital signal such as a power-down signal may control the start of the store phase, e.g. when the power-down signal is in the high state. When the power-down signal goes e.g. from a low state to a high state, it may indicate that the entire circuitry in the SoC is going to be power-gated. The write enable signal may be activated based on the power-down signal alone, in a system-level control, or, alternatively, the write enable signal may be activated based on a combination of the power-down signal and the system clock signal. The clock signal is a digital signal that oscillates between the low state and the high state with a given frequency. The clock signal may be generated by a clock generator circuit. Unless otherwise specified, a clock signal has a duty cycle of 50%, i.e. the first level and the second level have the same duration. The non-volatile storage circuit may be configured to receive the clock signal.

The write operation may be such that the write component writes at once to the first pair of non-volatile memories the bit value and the complementary bit value. In other words, with only one write operation (e.g. by making one electrical current flow in both non-volatile memories) the bit value may be written to one of the first pair of non-volatile memories and the complementary bit value may be written to the other of the first pair of non-volatile memories. The same applies for the second pair of non-volatile memories. Accordingly, the write component may be configured to write the first data into the first pair of non-volatile memories by writing the bit value of the first data into a first non-volatile memory of the first pair and the complementary bit value of the first data into a second non-volatile memory of the first pair. Similarly, the write component may be configured to write the second data into the second pair of non-volatile memories by writing the bit value of the second data into a first non-volatile memory of the second pair and the complementary bit value of the second data into a second non-volatile memory of the second pair.

Further, the write component writes at the same time the first data in the first pair of non-volatile memories and the second data in the second pair of non-volatile memories. Accordingly, the write component may perform two write operations simultaneously, e.g. making an electrical current flow in the first pair of non-volatile memories and making another electrical current flow in the second pair of non-volatile memories. Exemplarily, both write operations may be triggered by the same control signal, i.e. the write enable signal.

Additionally, in order to allow for two simultaneous write operations, the write component may exemplarily comprise at least two independent paths leading to the pairs of non-volatile memories. In other words, the path connecting the write component to the first pair of non-volatile memories may be physically distinct from and without any connection to the path connecting the write component to the second pair of non-volatile memories.

In one example, the write component may comprise two separate parts. The two parts are separate in that each is configured to receive only one data signal out of the two data signals, i.e. it is connected only to one flip-flop circuit, and each is connected to only one pair of non-volatile memories. Both parts may be activated by the same write enable signal so that the write operation is performed simultaneously for both pairs of non-volatile memories.

Exemplarily, the non-volatile storage circuit may comprise one or more separating elements, such as transmission gates, which can selectively block or pass electrical current. The separating elements may e.g. separate the first pair of non-volatile memories from the second pair of non-volatile memories during the write phase, i.e. cut off any connection in-between, so that the write operations do not influence each other. Indeed, the first pair of non-volatile memories and the second pair of non-volatile memories may be indirectly connected to each other by being both connected to the read component. Further, the separating elements may isolate the write component from the read component. Exemplarily, the non-volatile storage circuit may comprise two separating elements.

These parts of the write component are identical to the storage elements (cross-coupled two inverters of master or slave latches) of the conventional CMOS flip-flop, therefore, the write data can be directly driven through them, provided that they deliver sufficiently high current that can switch the non-volatile storage cells. In this case, they have to be separated with separating elements that can be controlled with the read enable signal. Indeed, the non-volatile memories may be very sensitive to how the write operation is conducted, e.g. to the current value and its duration of flow, so that any minor disturbance in the current level during the write operation can lead to an error. Accordingly, when "merging" two conventional single-bit shadow latches, the write components may be left substantially unvaried, while the read components and other elements may be modified for optimization of area and energy consumption, as explained below.

Once the store phase is over, a power gating signal, which may also be a digital signal, may be set to a high state to actually turn off the power supply to the idle flip-flop circuits.

When the flip-flop circuits are awakened, it is necessary to transfer the first data and second data back to the flip-flop circuits. To this purpose, the non-volatile storage circuit further comprises a read component connected to the first pair of non-volatile memories and to the second pair of non-volatile memories. The read component is configured to read the first data from the first pair of non-volatile memories and the second data from the second pair of non-volatile memories.

Further, since the data are supposed to be restored to the flip-flop circuits in which they were originally (i.e. prior to the write phase) stored, the read component may be connected also to the first flip-flop circuit and the second flip-flop circuit and may be configured to transmit the first data and the second data thereto. Accordingly, the phase during which the read component reads the first data and the second data from the first pair of non-volatile memories and the second pair of non-volatile memories, respectively, may be called "read phase" or "restore phase".

The read phase is triggered as soon as power supply is provided again to the first flip-flop circuit and the second flip-flop circuit. In particular, the power-down signal may control the start of the read phase, e.g. when the power-down signal is in the low state. In other words, one state of the power-down signal may trigger the write phase and the other state of the power-down signal may trigger the read phase. In one example, the control signals for the read component may be activated based on the power-down signal alone, in a system-level control, or, alternatively, the control signals may be activated based on a combination of the power-down signal and the system clock signal. As discussed below, in one example the read component may receive four control signal and in another example the read component may receive two control signals.

Exemplarily, the read component may perform a read operation by making an electrical current flow in the two non-volatile memories of a given pair. As explained before, the non-volatile memories in each pair store both the bit value and the complementary bit value. Accordingly, the read component may be configured to read both values at the same time.

However, unlike the write component, the read component is energy- and area-optimized for reading two (or more) bits, because the read component is "truly" shared between the first pair of non-volatile memories and the second pair of non-volatile memories. This means that the read component cannot read the first data and the second data simultaneously and is instead configured to do it sequentially, i.e. one after the other. Therefore, the read component performs two read operations in a temporal sequence, beginning the second read operation only once the first read operation is completed.

Accordingly, the read component is configured such that, at a given time, it can read only the first data or only the second data. Thus, at least partially, the same circuit elements are used for reading both the first data and the second data, thereby reducing the required area for the two-bit shadow latch in comparison to two single-bit shadow latches. Further, the energy necessary for reading is also reduced because the read component is designed such that there is a fewer number of transitions with respect to a case in which two conventional one-bit non-volatile latches are used. A transition is a change in the logic level of a node or a circuit element, i.e. from 0 to 1 or vice versa, and it requires a certain amount of energy.

The non-volatile storage circuit further comprises two output nodes; the read component comprises a pre-charge component connected to the two output nodes; when reading the first data from the first pair of non-volatile memories: the pre-charge component is configured to equalize the two output nodes at supply voltage and the first pair of non-volatile memories is connected to ground; and when reading the second data from the second pair of non-volatile memories: the pre-charge component is configured to equalize the two output nodes at ground voltage and the second pair of non-volatile memories is connected to a supply voltage source. Of course, the roles/positions of the first pair of non-volatile memories and the second pair of non-volatile memories may be exchanged.

The output nodes are the nodes to which the values of the data stored in the non-volatile memories are propagated, or, in other words, the nodes at which the output of the read operation is obtained. Specifically, at a first output node the bit value of the (first or second) data may be obtained, while at a second output node the complementary bit value of the (first or second) data may be obtained.

The output nodes may be connected to the first flip-flop circuit and the second flip-flop circuit. Exemplarily, the connection between the output nodes and the flip-flop circuits may comprise a selector element, so that the read data may be transmitted to the respective flip-flop circuit. For example, the selector element may be such that, when the first data are read, it connects the output nodes to the first flip-flop circuit and cuts out the second flip-flop circuit, and similarly, when the second data are read, it connects the output nodes to the second flip-flop circuit and cuts out the first flip-flop circuit. In one example, the selector element may be a demultiplexer with a select signal controlled globally at system level.

The read component comprises a pre-charge component connected to the two output nodes, which is configured to equalize the two output nodes so that correct read operations may be performed afterwards. The pre-charge component is different from conventional pre-charge components in that it can equalize the output nodes to two different voltage levels, namely at about the supply voltage V_{dd} to the circuit, e.g. 1.5 V or 1 V, and at about the ground voltage, i.e. 0 V. In this way, it is possible to create an adequate electric potential difference for letting an electrical current flow through the non-volatile memories both for the first pair of non-volatile memories and the second pair of non-volatile memories, as explained below.

The pre-charge component may comprise two identical parts, each part connected to one output node, and each part configured to receive two input signals, with one signal configured to connect the output nodes to a supply voltage source and the other signal configured to connect the output nodes to ground. Exemplarily, each part may comprise two electronic switches, each electronic switch activated by one of the two signals. An electronic switch has an "on" state, in which current can flow through the switch, and an "off" state, in which, ideally, current cannot flow through the switch. The on/off state of the electronic switch may be set by a control signal. Accordingly, a first electronic switch in a part of the pre-charge component may be connected to ground and, when turned on by a first signal, connect the output node to ground. Similarly, a second electronic switch in a part of the pre-charge component may be connected to a supply voltage source and, when turned on by a second signal, connect the output node to it. The two electronic switches may be transistors, e.g. two metal-oxide-semiconductor field-effect transistors (MOSFETs) such as a p-channel MOSFET (PMOS) and an n-channel MOSFET (NMOS).

The pre-charging operation performed by the pre-charge component may constitute a first stage of the read phase, the pre-charge stage, in which the output nodes are equalized. The actual reading may take place in a subsequent stage of the read phase, namely the evaluation stage, in which the pre-charge component may be disabled. Since two subsequent read operations take place, there are actually two pre-charge stages and two evaluation stages. Specifically, a first pre-charge stage and a first evaluation stage are for reading the first data and are followed by a second pre-charge stage and a second evaluation stage for reading the second data.

During the evaluation stages, the first pair of non-volatile memories may be connected to ground, i.e. to the reference value of 0 V, while the second pair of non-volatile memories may be connected to a supply voltage source with supply voltage V_{dd}. Exemplarily, one pair of non-volatile memories may be connectable to the supply voltage source and the other pair of non-volatile memories may be connectable to ground by means of activation/deactivation elements such as electronic switches (e.g. transistors). These components may indeed activate or deactivate the read component in that they may allow current to flow through the non-volatile memories so that the data can be read. Accordingly, the read component further comprise a first activation/deactivation element and a second activation/deactivation element.

In particular, the activation/deactivation elements may be turned on/off by the same control signal, a read enable signal. Accordingly, both may be on when the first data are read as well as when the second data are read. In any case, for reading given data, both activation/deactivation elements should be on for both read operations in order to facilitate developing a read current path by establishing a proper connection between ground and supply voltage.

The first pair of non-volatile memories and the second pair of non-volatile memories may also be connected to the output nodes. In particular, the non-volatile memory cells may each have two terminals, one terminal connected to the respective activation/deactivation element and the other terminal connected (possibly via other elements) to one output node. When reading the first data, electrical current may flow through the first pair of non-volatile memories due to the potential difference between ground and the output nodes at V_{dd}. When reading the second data, electrical current may flow through the second pair of non-volatile memories due to the potential difference between V_{dd} and the output nodes at ground.

It should be noted that the one or more separating elements discussed with reference to the write component may be configured to keep the first pair of non-volatile memories and the second pair of non-volatile memories isolated from each other also during the pre-charge stage. Instead, during the evaluation stage, the separating elements may be configured to let signals through. Exemplarily, the separating element(s) may be controlled by the same control signal that controls the activation/deactivation elements, i.e. the read enable signal.

The read component comprises a first stabilizing element and a second stabilizing element for ensuring a correct functioning of the non-volatile storage circuit. The first stabilizing element may be configured to prevent the connection between the read component and the first pair of non-volatile memories from affecting reading of the second data; and the second stabilizing element may be configured to prevent the connection between the read component and the second pair of non-volatile memories from affecting reading of the first data.

The read component comprises a sense amplifier including a first inverter and a second inverter, each inverter comprising two transistors, wherein each output node is connected to an inverter and the pre-charge component is connected to the output nodes via the sense amplifier; the read component further comprises a first stabilizing element interposed between the sense amplifier and the first pair of non-volatile memories and a second stabilizing element interposed between the sense amplifier and the second pair of non-volatile memories; the first stabilizing element is connected to the source terminals of a first transistor in the first inverter and a first transistor in the second inverter, the first transistors being each connected to a corresponding one of the non-volatile memories of the first pair of non-volatile memories, and the first stabilizing element is configured to equalize the source terminals of the first transistors while the second data are read; the second stabilizing element is connected to the source terminals of a second transistor in the first inverter and a second transistor in the second inverter, the second transistors being each connected to a corresponding one of the non-volatile memories of the second pair of non-volatile memories, and the second stabilizing element is configured to equalize the source terminals of the second transistors while the first data are read.

In other words, the two pairs of non-volatile memories may be connected on opposite sides of the sense amplifier, which comprises two back-to-back inverters, e.g. CMOS inverters comprising each PMOS and an NMOS.

When an electrical current flows through a pair of non-volatile memories, one of the output nodes instantly goes to a high steady state, while the other quickly reaches a low stable state, depending upon the bit values stored in each non-volatile memory. The stabilization process is accelerated due to the sense amplifier. Accordingly, the sense amplifier is active during the evaluation stage, which is triggered when the activation/deactivation elements are turned on. Thus, the activation/deactivation elements may particularly activate or deactivate the sense amplifier of the read component.

Each output node is connected to an output of a corresponding inverter and the pre-charge component is connected to the output nodes. In particular, each output node may be located between the two transistors of the inverter.

Each inverter has a first transistor that is "closer" to or on the same side of the first pair of non-volatile memories and a second transistor that is "closer" to or on the same side of the second pair of non-volatile memories. Accordingly, although all transistors are indirectly connectable to all non-volatile memories, it is said that the first transistors are each connected to one of the non-volatile memories in the first pair to indicate that e.g. the first element that a current coming from a non-volatile memory in the first pair encounters in the sense amplifier is one of the two first transistors. Similarly, the first element that a current coming from a non-volatile memory in the second pair encounters in the sense amplifier is one of the two second transistors.

Since the read component, and in particular the sense amplifier, is shared between the first pair of non-volatile memories and the second pair of non-volatile memories, reading of the first data may be affected by the presence of the second pair of non-volatile memories and vice versa. For example, if the non-volatile memories store the bit values in the form of a resistance state, the resistance states of one pair may affect the reading of the other pair. Accordingly, the first stabilizing element and the second stabilizing element may be provided to remove this risk.

The stabilizing elements may be electronic switches that, when on, connect the source terminals of the respective transistors to one another, thereby neutralizing any effect of the resistance states of the non-volatile memories. In particular, a branch comprising a stabilizing element may be a bridge between two branches comprising a transistor and a non-volatile memory on one side and two branches comprising a transistor and a non-volatile memory on the other side. In other words, the non-volatile storage circuit may comprise four nodes, wherein each node is the junction of a branch comprising a transistor of the sense amplifier, a branch comprising a stabilizing element and a branch comprising a non-volatile memory.

In the examples comprising the separating elements, a separating element may be on the path between the non-volatile memory and the node with the stabilizing element and the transistor of the sense amplifier. Since four separating elements would be redundant, a pair of separating elements may be sufficient. Accordingly, the pair of separating elements may be connected either to the first pair of non-volatile memories or to the second pair of non-volatile memories. Thus, it should be noted that the separating elements make the non-volatile storage circuit asymmetric. Indeed, the non-volatile storage circuit may be considered as having the sense amplifier and the pre-charge component in the middle and then one each side a stabilizing element, a part of the write component, a pair of non-volatile memories and an activation/deactivation element. Further, only one side, a pair of separating elements is present.

Incidentally, the control signal that connects the output nodes to ground may also be activated during the write phase in order to enable a correct write operation for the pair of non-volatile memories that is not connected to the sense amplifier via the separating elements.

The first stabilizing element may be on when the second data are read and off when the first data are read, while the second stabilizing element may be on when the first data are read and may be off when the second data are read. Accordingly, the two stabilizing elements may be controlled by the same control signal but have different logic so that one is active high and the other is active low.

To summarize, the read phase may be controlled by four input signals, the read enable signal, two signals for the pre-charge component and one signal for the stabilizing elements. The dependencies on these signals can be optimized to reduce it to two input signals. In a particular embodiment, the pre-charge component and the first and second stabilizing elements may be configured to be controlled by a common control signal. Specifically, the first and second stabilizing elements may be controlled only by the common signal, while the pre-charge component may be controlled by the common signal and the read enable signal.

In this embodiment, each part of the pre-charge component may comprise four transistors instead of two. A first transistor may be connected to ground, a second transistor may be connected to the first transistor and a third transistor, which in turn may be connected to a fourth transistor, which is connected to a supply voltage source. The output node may be located between the second and third transistors. The first and fourth transistors may be controlled by the common signal, however the latter being active low and the former being active high, and the third and fourth transistors may be controlled by the read enable signal and be both active low. The first stabilizing element may be active low and second stabilizing element may be active high.

During the pre-charge stage in which the output nodes are equalized to V_{dd}, both the common signal and the read enable signal may be in a low state, so that the fourth transistor is on and pre-charging can occur but reading is not enabled. During the subsequent evaluation stage for reading the first data, both the common signal and the read enable signal may be in a high state. In this way, the pre-charge component is disabled and the sense amplifier is active, with the second stabilizing element neutralizing the effect of the second pair of non-volatile memories. During the pre-charge stage in which the output nodes are equalized to ground, the common signal may be in a high state while the read enable signal may be in a low state, so that the first transistor is on and pre-charging can occur but reading is not enabled. During the subsequent evaluation stage for reading the second data, the common signal and the read enable signal may be in a high state. In this way, the pre-charge component is disabled and the sense amplifier is active, with the first stabilizing element neutralizing the effect of the first pair of non-volatile memories.

There is a possibility that more than two flip-flop circuits can be placed adjacent in an architecture. In the above-described design, the number of storage bits can be easily scaled. In other words, the non-volatile storage circuit may further store additional data from one or more additional flip-flop circuits.

In one particular embodiment, the non-volatile storage circuit may comprise one or more additional pairs of non-volatile memories and at least one selector element, wherein: the write component is connected to the additional pair(s) of non-volatile memories; at power-down of the flip-flop circuits, the write component is further configured to write additional data in the additional pair(s) of non-volatile memories simultaneously to the first data and the second data; the read component is connected to at least two pairs of non-volatile memories via the at least one selector element; and, at power-up of the flip-flop circuits, the read component is further configured to sequentially read the additional data.

In this case, more than two flip-flop circuits are affected by power gating and need backup.

Accordingly, the non-volatile storage circuit may comprise at least a third pair of non-volatile memories, and possibly a fourth pair, a fifth pair and so on. Each additional pair of non-volatile memories is configured to store respective additional data, so that the additional data may comprise at least third data, and possibly fourth data, fifth data and so on.

The write component is connected to the additional pair(s) of non-volatile memories and is configured to receive the additional data from the additional pair(s) of non-volatile memories. Accordingly, the write component may receive at least three data signals and the write enable signal. In particular, the write component may comprise a number of separate parts corresponding to the total number of pairs of non-volatile memories, including the first pair of non-volatile memories and the second pair of non-volatile memories. The connection of the write component is, thus, similar to that already described. The additional data are written at the same time of the first data and the second data.

The non-volatile storage circuit further comprises at least one selector element. Exemplarily, the at least one selector element may be a multiplexer.

Specifically, the non-volatile storage circuit may comprise either one selector element, in case there is only a third pair of non-volatile memories or two selector elements, in case there is at least a fourth pair of non-volatile memories. When there is only a third pair, the single selector element may be configured to select between two pairs of non-volatile memories, i.e. the first and the third pair or the second and the third pair. When there are a third and a fourth pair as additional pairs, both selector elements may be configured to select between two pairs of non-volatile memories. When more than two additional pairs of non-volatile memories are present, i.e. more than four pairs of non-volatile memories in total, both selector elements may be configured to select among more than two pairs of non-volatile memories.

The read component is connected to the additional pairs of non-volatile memories via the one or two selector elements. The read operations are performed as explained above, wherein the role of the first pair of non-volatile memories is taken sequentially by each pair of non-volatile memories connected to the same selector element as the first pair of non-volatile memories and the role of the second pair of non-volatile memories is taken sequentially by each pair of non-volatile memories connected to the same selector element as the second pair of non-volatile memories. The read component may sequentially read all pairs connected to a first selector element first and then all pairs connected to a second selector element, or the sequence may alternate between first and second selector element.

The stabilizing elements would be positioned between the sense amplifier and the selector element(s).

The non-volatile storage circuit may further comprise an additional activation/deactivation element for each additional pair of non-volatile memories. During read operation, the activation/deactivation element for the pair whose data need to be read must be on, as well as at least one of the activation/deactivation element on the other side of the sense amplifier.

In particular, in this embodiment, the at least one selector element may embody the one or more separating elements that can be deactivated during the write phase to avoid any sneaky write current path.

One aspect of the present invention relates to a multi-bit non-volatile memory comprising a non-volatile storage circuit as described above. In particular, a two-bit non-volatile memory comprises the non-volatile storage circuit with only the first pair of non-volatile memories and the second pair of non-volatile memories and the first flip-flop circuit and the second flip-flop circuit connected to the read component and to the write component. At power-down of the multi-bit non-volatile memory, the first flip-flop circuit is configured to transmit the first data to the write component and the second flip-flop circuit is configured to transmit the second data to the write component; and at power-up of the multi-bit non-volatile memory, the first flip-flop circuit is configured to receive the first data from the read component and the second flip-flop circuit is configured to receive the second data from the read component.

The multi-bit non-volatile memory is powered down as a whole, so that power-down of the multi-bit non-volatile memory includes, of course, the power-down of the flip-flop circuits. As discussed before, a high-state power down signal triggers the write phase of the non-volatile storage circuit. The first data and second data that are received by the write component from the first flip-flop circuit and the second flip-flop circuit, respectively. Then, at power-up of the multi-bit non-volatile memory, i.e. of the flip-flop circuits, the read component transmits the first data and the second data to the first flip-flop circuit and the second flip-flop circuit, respectively.

As explained above, in some examples the operations may be controlled by the clock signal. The multi-bit non-volatile memory may comprise at least one clock buffer, wherein the at least one clock buffer is shared between the first flip-flop circuit and the second flip-flop circuit. Buffers are typically required to generate the clock skew in order to better synchronize the design. Since the clock signal is one of the inputs to the flip-flop circuits, these buffers are connected to the clock wire before it actually gets connected to the flip-flop. Hence, if the two flip-flop circuits are very close to each other, the same buffers can be utilized to drive the clock signal.

A multi-bit non-volatile memory for more than two bits may comprise a non-volatile storage circuit comprising at least one additional pair of non-volatile memories as described above and a plurality of flip-flop circuits connected to the read component and to the write component, wherein the number of flip-flop circuits corresponds to the total number of pairs of non-volatile memories. At power-down of the multi-bit non-volatile memory, each flip-flop circuit is configured to transmit respective data among the first, second and additional data to the write component; and at power-up of the multi-bit non-volatile memory, each flip-flop circuit is configured to receive respective data among the first, second and additional data from the read component.

Each flip-flop circuit is associated to a pair of non-volatile memories, which stores the data when no power is supplied to the volatile flip-flop circuit. As explained above, additional data may comprise at least third data and possibly fourth data, fifth data and so on. With more than two flip-flop circuits, each flip-flop circuit transmits and receives its own respective data, e.g. the third flip-flop circuit transmits and receives third data, the fourth flip-flop circuit transmits and receives fourth data and so on.

One aspect of the present invention relates to a memory device comprising one or more multi-bit non-volatile memories as described above.

In a particular embodiment, the memory device comprises plural multi-bit non-volatile memories.

In a particular embodiment, the memory device is usable as the main memory or the working memory of a computing device, such as a personal computer, a laptop computer, mobile phone, a tablet computer, or any such device.

In a particular embodiment, the memory device is usable as the random access memory of a computing device, such as a personal computer, a laptop computer, mobile phone, a tablet computer, or any such device.

One aspect of the present invention relates to a computing device comprising one or more memory devices as described above.

One aspect of the present invention relates to a microprocessor comprising one or more multi-bit non-volatile memories as described above. In a preferred embodiment, the microprocessor comprises plural multi-bit non-volatile memories as on-chip memory.

One aspect of the present invention relates to a microcontroller comprising one or more multi-bit non-volatile memories as described above. In a preferred embodiment, the microprocessor comprises plural multi-bit non-volatile memories as on-chip memory.

One aspect of the present invention relates to a method for operating a non-volatile storage circuit as described above, the method defined by claim 8 comprising: at power-down of the first flip-flop circuit and the second flip-flop circuit, simultaneously writing, by the write component, the first data to the first pair of non-volatile memories and the second data to the second pair of non-volatile memories; and
at power-up of the first flip-flop circuit and the second flip-flop circuit, sequentially reading, by the read component, the first data from the first pair of non-volatile memories and the second data from the second pair of non-volatile memories.

In particular, when a power-down signal is activated, indicating imminent power gating, the write enable signal and the signal connecting the pre-charge component to ground may be activated, while the other control signals, i.e. the signal controlling the stabilizing elements, the signal connecting the pre-charge component to V_{dd} and the read enable signal, may remain inactive.

Conversely, when the power-down signal is deactivated, i.e. at power-up, when power supply is resumed, the write enable signal is deactivated. The first data and the second data are read sequentially, meaning that e.g. the first data are read first and, only after that, the second data are read (or vice versa).

For the pre-charge stage for the first data, the signal connecting the pre-charge component to V_{dd} may be activated, while the other control signals for the read component, in particular the read enable signal, may be inactive. For the evaluation stage of the first data, the signal connecting the pre-charge component to V_{dd} may be deactivated and the read enable signal may be activated, while the other control signals may be inactive. The first data are then transmitted to the first flip-flop circuit. During both stages for the first data, the signal controlling the stabilizing elements may be inactive so that the second stabilizing element is on and the read operation of the first data are not disturbed.

Subsequently, for the pre-charge stage for the second data, the signal connecting the pre-charge component to ground may be activated, as well as the signal controlling the stabilizing elements, so that the first stabilizing element is on and the read operation of the second data are not disturbed. The read enable signal is deactivated and the signal connecting the pre-charge component to V_{dd} remains inactive. For the evaluation stage of the second data, the signal connecting the pre-charge component to ground may be deactivated and the read enable signal may be activated, with the other signals maintaining the state they had during the pre-charge stage. The second data are then transmitted to the second flip-flop circuit.

In the case of more than two flip-flop circuits, the method comprises simultaneously writing of all data, i.e. first data, second data and additional data, to the respective pairs of non-volatile memories when all flip-flop circuits are powered down. Instead, at power-up of all flip-flop circuits, the read component reads all data sequentially, e.g. the first data, then the second data, then third data, then fourth data and so on.

To summarize, the proposed multi-bit shadow latch architecture is designed based on a sharing mechanism, which can merge the neighboring single-bit non-volatile components in the layout. In this design, the non-volatile memory cells are organized around the read component in such a way that the same elements can be used to read two bits, leading to a significant area and energy reduction. The functionality in this design is controlled in a unique way to perform a reliable back-up and restore operation.

### Brief Description of the Drawings

Details of exemplary embodiments are set forth below with reference to the exemplary drawings. Other features will be apparent from the description, the drawings, and from the claims. It should be understood, however, that even though embodiments are separately described, single features of different embodiments may be combined to further embodiments.
Figure 1 shows a schematic representation of a volatile flip-flop according to the prior art.
Figure 2a shows a schematic representation of a non-volatile shadow flip-flop according to the prior art.
Figure 2b shows an example of a non-volatile shadow latch according to the prior art.
Figure 3 shows a schematic representation of a multi-bit non-volatile shadow flip-flop.
Figure 4 shows a schematic representation of a non-volatile storage circuit for a two-bit non-volatile shadow flip-flop.
Figure 5 shows another schematic representation of a non-volatile storage circuit for a two-bit non-volatile shadow flip-flop.
Figure 6 shows an example of a non-volatile storage circuit for a two-bit non-volatile shadow flip-flop.
Figure 7 shows a spin-transfer-torque-based magnetic tunnel junction cell.
Figure 8 shows the operations of a non-volatile storage circuit with respect to the control signals.
Figure 9 shows an exemplary way of generating control signals for a non-volatile storage circuit.
Figure 10a shows an exemplary pre-charge component.
Figure 10b shows the control signals for the exemplary pre-charge component of Figure 10a.
Figure 11 shows a schematic representation of a two-bit non-volatile shadow flip-flop.
Figure 12 shows a schematic representation of a non-volatile storage circuit for a three-bit non-volatile shadow flip-flop.
Figure 13 shows a schematic representation of a non-volatile storage circuit for a four-bit non-volatile shadow flip-flop.
Figure 14 shows a schematic representation of a non-volatile storage circuit for an N-bit non-volatile shadow flip-flop.
Figure 15 shows a floorplan of standard memory cells.

### Detailed Description

In the following, a detailed description of examples will be given with reference to the drawings. It should be understood that various modifications to the examples may be made. Unless explicitly indicated otherwise, elements of one example may be combined and used in other examples to form new examples.

In general, in an SoC, the placement of standard cells is done in an automated way using Electronic Design Automation (EDA) tools. During this process, regardless of the timing constraints, a large number of flip-flops are placed very close to each other. The non-volatile shadow components for such flip-flops are also placed close by, which means that some of the circuit components that are common to these shadow parts can be merged.

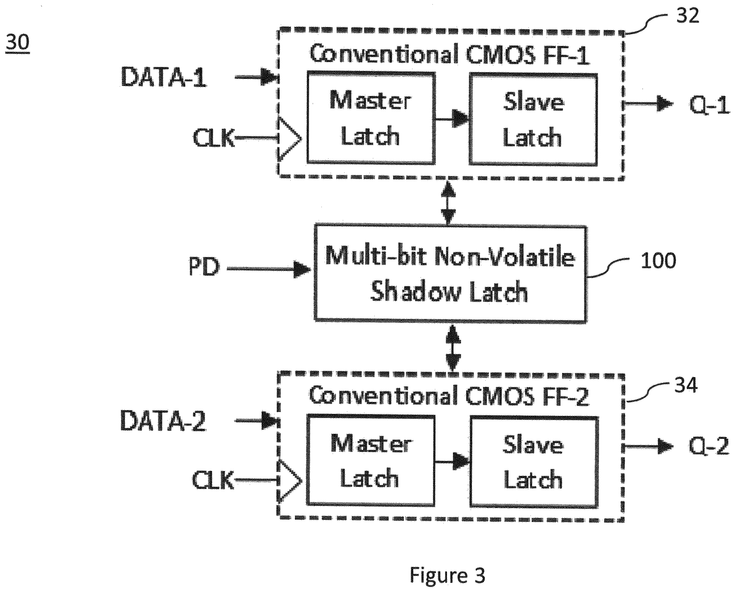

**Figure 3** shows a schematic representation of a multi-bit non-volatile shadow flip-flop 30, in particular of a two-bit non-volatile shadow flip-flop. The multi-bit non-volatile shadow flip-flop 30 comprises a first flip-flop circuit 32, a second flip-flop circuit 34 and a non-volatile storage circuit (or multi-bit non-volatile shadow latch) 100. As shown, the multi-bit non-volatile shadow latch is shared between the two conventional flip-flops, e.g. CMOS flip-flops. Here, values from these two conventional flip-flops are stored in the shadow latch during the power-down mode before disconnecting the power supply. During power-up, values from the shadow latch are restored back to their respective flip-flops, so that the normal operation can be resumed. These store and restore operations are controlled using a common PD pin.

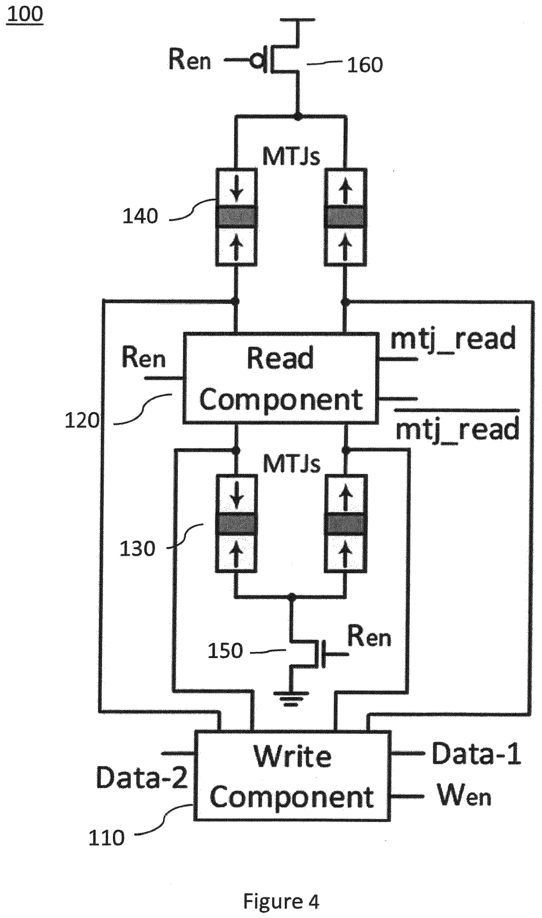

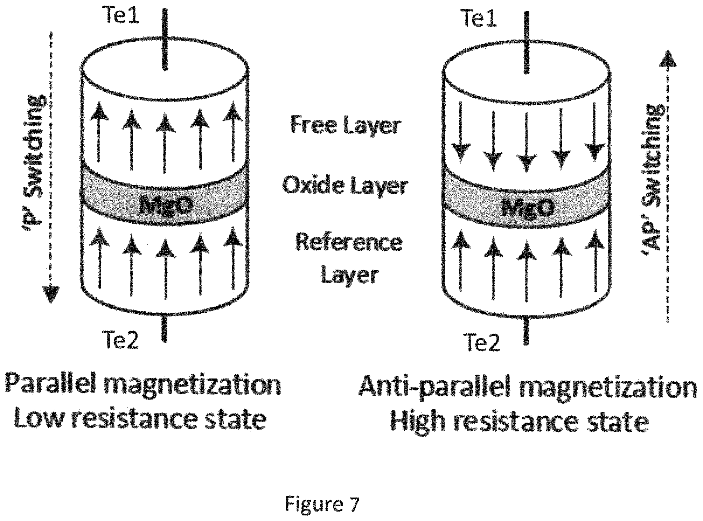

**Figure 4** shows a schematic representation of the non-volatile storage circuit 100 for a two-bit non-volatile shadow flip-flop 30. The non-volatile storage circuit 100 comprises a write component 110, a read component 120, a first pair of non-volatile memories 130 and a second pair of non-volatile memories 140. In particular, the non-volatile memories are MTJ cells using the STT technology, which are described in more detail below with reference to Figure 7. Further, the read component 120 comprises two activation/deactivation elements, a first activation/deactivation element 150 connected to the first pair of non-volatile memories 130 and a second activation/deactivation element 160 connected to the second pair of non-volatile memories 140. The activation/deactivation elements 150, 160 may be separated from the rest of the read component 120.

The read component 120, including the activation/deactivation elements 150, 160, is controlled, among others, by a read enable signal, while the write component 100 is controlled by a write enable signal. In particular, the first activation/deactivation element 150 can connect or disconnect the first pair of non-volatile memories 130 to/from ground and it may be e.g. an NMOS. The second activation/deactivation element 160 can connect or disconnect the second pair of non-volatile memories 140 to/from a supply voltage source and it may be e.g. a PMOS. Further, the write component 110 receives two data signals as input and the read component 120 provides two outputs.

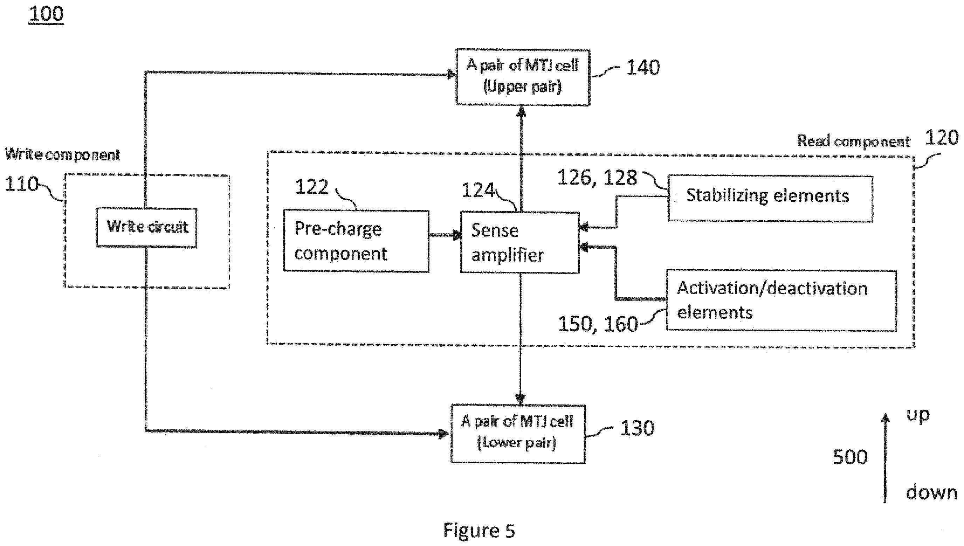

**Figure 5** shows another schematic representation of a non-volatile storage circuit 100 for a two-bit non-volatile shadow flip-flop 30, in which the different parts of the read component 120 are shown. The read component 120 comprises, besides the activation/deactivation elements 150, 160, a pre-charge component 122, a sense amplifier 124 and first and second stabilizing elements 126, 128. In particular, the pre-charge component 122, the sense amplifier 124 and the stabilizing elements 126, 128 may be located between the first pair of non-volatile memories 130 and the second pair of non-volatile memories 140.

Unlike the standard non-volatile shadow latch 23 shown in Figure 2, in Figures 4 and 5 there are two MTJ cells connected on one side the sense amplifier 124 of the read component 120 and two MTJ cells connected on the other side of the sense amplifier 124 of the read component 120. In particular, one pair can be referred to as "upper pair" and the other as "lower pair", when defining a direction as given by arrow 500.

In this way, the circuit elements such as the read component 120 and other controlling circuits can be merged. On the other hand, the write component 110 remains substantially unmodified with respect to a standard non-volatile shadow latch in order to maintain an error-free storing. This is due to the fact that the MTJ store operation is very sensitive to the current value and its duration of flow, and any minor disturbance in the current level during the write operation can easily lead to an error. Additionally, the write component 110 can be easily overlapped with the master/slave circuitry of the conventional CMOS flip-flop design.

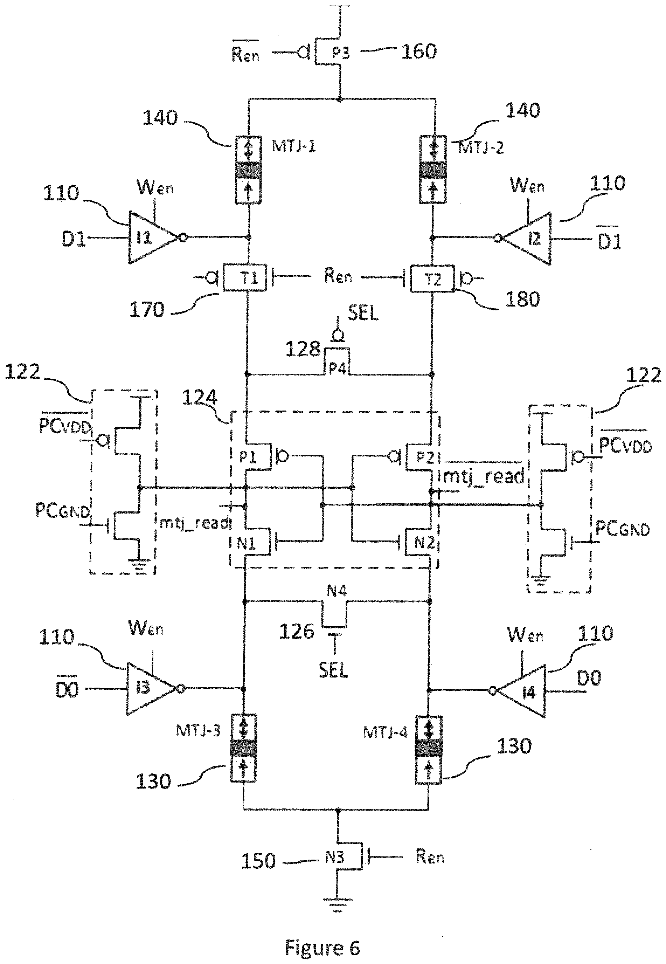

The implementation of the non-volatile storage circuit 100 of Figures 4 and 5 may be achieved through different designs. **Figure 6** shows an exemplary transistor-level schematic of a non-volatile storage circuit 100 for a two-bit non-volatile shadow flip-flop 30.

The first activation/deactivation element 150 comprises an NMOS N3 and the second activation/deactivation element 160 comprises a PMOS P3. Both activation/deactivation elements are controlled by the read enable signal Rₑₙ in such a way that they turn on/off together. The first activation/deactivation element 150 regulates the connection to ground, while the second activation/deactivation element 160 regulates the connection to the supply voltage source.

The first pair of non-volatile memories 130 comprises two MTJ cells MTJ-3 and MTJ-4 and each is directly connected, i.e. without any other elements in-between, to the first activation/deactivation element 150. The second pair of non-volatile memories 140 comprises two MTJ cells MTJ-1 and MTJ-2 and each is directly connected, i.e. without any other elements in-between, to the second activation/deactivation element 160.

**Figure 7** shows an STT-based MTJ cell. An MTJ cell is a component consisting of two ferromagnetic layers separated by a thin insulator (such as an oxide layer). According to quantum mechanics, electrons can tunnel from one ferromagnetic layer into the other. If the magnetizations of the two layers are in a parallel orientation (P magnetization state) it is more likely that electrons will tunnel through the insulator than if they are in the antiparallel orientation (AP magnetization state). MTJ cells are well known to the skilled person in this technical field. Consequently, a MTJ cell can be switched between two states of electrical resistance, one with low and one with very high resistance. The magnetization direction in the MTJs may be used for data storage, wherein '0' and '1' correspond to parallel and antiparallel magnetizations in the MTJ cell, respectively.

In order to control the magnetization of the ferromagnetic layers, different techniques may be employed, such as applying an external magnetic field or using a spin-polarized current to exploit the spin-transfer torque effect. In this exemplary implementation, the STT effect is exploited, and the information bits can be written by passing a current through a MTJ.

An STT-based MTJ cell is shown in Figure 7 as a two-terminal storing device. As explained, the value is stored in the STT-MTJ cell in the form of a resistance state influenced by the two ferromagnetic layers. Out of these two layers, one has always fixed magnetization (reference layer) and the other one (free layer) is varying based on the direction of the write current. The read is performed by passing a low current through the terminals. To write a value, the magnetic orientation of the free layer is changed to either P or AP configuration, using a write current that flows between the two terminals. If the write current flows from 'Te1' to 'Te2', it leads to a 'P' state switching, while if the write current flows from 'Te2' to 'Te1', it leads to an 'AP' state switching.

Going back to Figure 6, the write component 110 comprises four tristate inverters I1, I2, I3 and I4, with the control signal for all of them being the write enable signal Wₑₙ. The pairs I1-I2 and I3-I4 may constitute two separate parts of the write component 100. The input data signal for I3 and I4 is the first data signal from the first flip-flop circuit 32, wherein the bit value of the first data is applied to inverter I4 and the complementary bit value is applied to inverter I3. The input data signal for I1 and I2 is the second data signal from the second flip-flop circuit 34, wherein the bit value of the second data is applied to inverter I1 and the complementary bit value is applied to inverter I2. Each inverter is directly connected to an MTJ cell to which it sends a write current to store a bit value.

After the nodes joining the MTJ cells and the inverters of the write component 110, there are the nodes to the stabilizing elements. The first stabilizing element 126 comprises an NMOS N4 and the second stabilizing element 128 comprises a PMOS P4. Both stabilizing elements are controlled by a stabilizing signal SEL in such a way that when one is on, the other is off. Each stabilizing element 126, 128 is connected to both MTJ cells in a given pair. In one case, e.g. for the first stabilizing element 126, the connection is direct, while in the other case, e.g. for the second stabilizing element 128, there are two separating elements 170, 180 on the path between the MTJ cells of the second pair of non-volatile memories 140 and the second stabilizing element 128. In another example, the separating elements 170, 180 may be between the MTJ cells of the first pair of non-volatile memories 130 and the first stabilizing element 126.

In any case, the non-volatile storage circuit 100 comprises only one pair of separating elements 170, 180 to avoid redundancy. The separating elements 170, 180 are for example transmission gates and they are controlled by the read enable signal Rₑₙ as well. The separating elements 170, 180 can cut off the upper part of the non-volatile storage circuit 100, comprising the second pair of non-volatile memories 140 with relative activation/deactivation element 160 and second part (I1-I2) of the write component 110, from the rest of the non-volatile storage circuit 100. In particular, when the separating elements 170, 180 are off, they can avoid sneaky write current paths, allowing the writing of first data and second data to take place simultaneously without errors.

The stabilizing elements 126, 128 are interposed between the sense amplifier 124 and the MTJ cells. The sense amplifier 124 comprises two back-to-back inverters, each inverter including an NMOS and a PMOS. In particular, the PMOSs are connected to the second stabilizing element 128 and, via the separating elements 170, 180, to the second pair of non-volatile memories 140, while the NMOSs are connected to the first stabilizing element 126 and the first pair of non-volatile memories 130. An output node is connected to each inverter, for a total of two output nodes, 'mtj_read' and 'm̅t̅j̅_̅r̅e̅a̅d̅'. The output bit value and its complementary value are obtained at the nodes 'mtj_read' and 'm̅t̅j̅_̅r̅e̅a̅d̅', respectively.

The pre-charge component 122 comprises two symmetrical parts, each including two transistors. Each part of the pre-charge component 122 comprises an NMOS and a PMOS connected to each other, with the NMOS connected to ground and the PMOS connected to a supply voltage source. The PMOSs are controlled by a first signal PC_{Vdd} and the NMOSs are controlled by a second signal PC_{GND}. Each part of the pre-charge component 122 is connected to one inverter of the sense amplifier 124.

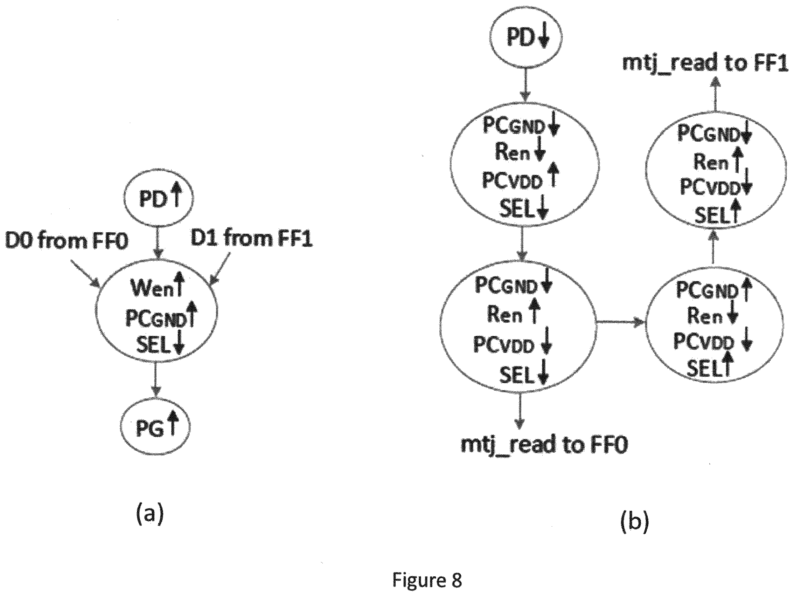

The operations of the non-volatile storage circuit 100 of Figure 6 will be described with reference to **Figure 8****,** which shows the operations of the non-volatile storage circuit in terms of the control signals. In particular, Figure 8a refers to the write phase and Figure 8b refers to the read phase. The control signals for the non-volatile storage circuit 100 are Wₑₙ, PC_{GND}, PC_{Vdd}, Rₑₙ and SEL, as illustrated above.

In an initial state, all control signals are inactive, i.e. in a low state. At power-down, i.e. when the PD signal is in a high state, the write enable signal Wₑₙ and the PC_{GND} are activated, while the others remain inactive. The store phase, thus, begins, wherein the two bit data, i.e. the first data and the second data, have to be written in the non-volatile memories 130, 140. To write the data, a definite amount of current has to pass through the MTJs for a given amount of time.

The tristate inverters of the write component 110 facilitate this write current to flow and the direction is decided based on the values of the input data signals. Both pairs of MTJ cells 130, 140 have two tristate inverters each, i.e. I3-I4 and I1-I2, which have always complementary inputs. If the first data from the first flip-flop circuit 32 comprise bit value D0 and complementary bit value D̅0̅, in order to write the first data to the first pair of non-volatile memories 130, the D0 is applied to the I4 inverter and its complimentary value D̅0̅ is applied to I3. If, for example, D0 is 0, the current flows from I4 to MTJ-4, MTJ-3 and sinks at I3. The write current flow direction leads to storing the opposite values D0, D̅0̅ in MTJ-3 and MTJ-4. Similarly, second data D1, D̅1̅ can be written to the upper pair of the MTJs 140. Since these two pairs of MTJs have independent paths, the data can be written in parallel.

Please note that, during the store phase, transistors P3, N3, transmission gates T1 and T2, and N4 are in the off state. The transistor P4 is in an on state, nevertheless it is isolated from the upper pairs of MTJ cells, as T1 and T2 are off. Hence, dedicated current paths are established for both pairs of MTJ cells and a reliable store operation to the non-volatile memories is performed. Furthermore, the 'mtj_read' and 'm̅t̅j̅_̅r̅e̅a̅d̅' nodes are at ground potential during the write operation, so that a proper write current path is established for MTJ3 and MTJ4. Since T1 and T2 are off, the upper pair MTJ1 and MTJ2 is anyway disconnected from the output nodes.

Once the write phase is completed, the power gating can occur.

Afterwards, when the memory is powered up, the PD signal is deactivated. Accordingly, the write enable signal Wₑₙ is deactivated and remains inactive for the whole read phase. The read phase comprises a first pre-charge stage, a first evaluation stage, a second pre-charge stage and a second evaluation stage, which correspond to the four circles in Figure 8b.

In the first pre-charge stage, the two output nodes are initially pre-charged at V_{dd} potential by activating PC_{Vdd}, while PC_{GND} is deactivated. Rₑₙ remains inactive as in the write phase, as well as SEL.

Afterwards, in the first evaluation stage, the pre-charge component 122 is disabled, i.e. PC_{Vdd} is deactivated, and the sensing process is activated by activating the Rₑₙ signal and turning on the N3 transistor, i.e. the first activation/deactivation element 150. Please note that the two transmission gates T1 and T2 are also turned on with the activation of the N3 transistor, as both of them are also controlled by the same control signal, i.e. Rₑₙ. Accordingly, these two transmission gates are in the off state during the pre-charge stage. During the evaluation stage, based on the resistance states of MTJ-3 and MTJ-4, the two output nodes stabilize at complimentary values. Additionally, during the first evaluation stage, the second stabilizing element 128, P4, is required to be in the on state, which is given by maintaining SEL inactive. When P4 is on, it equalizes the source terminals of the P1 and P2 transistors, to make sure that the resistance states of the second pair of non-volatile memories 140 do not affect the reading process of the first pair of non-volatile memories 130. Conversely, the transistor N4, i.e. the first stabilizing element 126, remains in the off state.

In the second pre-charge stage, the two output nodes are initially pre-charged at ground potential by activating PC_{GND}, while PC_{Vdd} remains inactive. Rₑₙ is deactivated while SEL is activated in order to turn on N4 and turn off P4.

In the second evaluation stage, the pre-charge component 122 is disabled, i.e. PC_{GND} is deactivated, and the sense amplifier 124 is enabled by activating Rₑₙ for turning on the second activation/deactivation element 160, the P3 transistor, and at the same time, the two transmission gates T1 and T2 are also turned on, like in the previous case. During the evaluation stage, based on the resistance states of MTJ-1 and MTJ-2, the two output nodes stabilize at complimentary values. Similar to the previous case, here the first stabilizing element 126, N4, is activated, so that the reading process of the second data is not disturbed by the resistance states of the lower pair of MTJs.

In both evaluations stages, based on the resistance values of the MTJ cells, one of the output nodes stabilizes at the logic low level and the other one at the logic high level, and these read values are propagated to their respective active flip-flops.

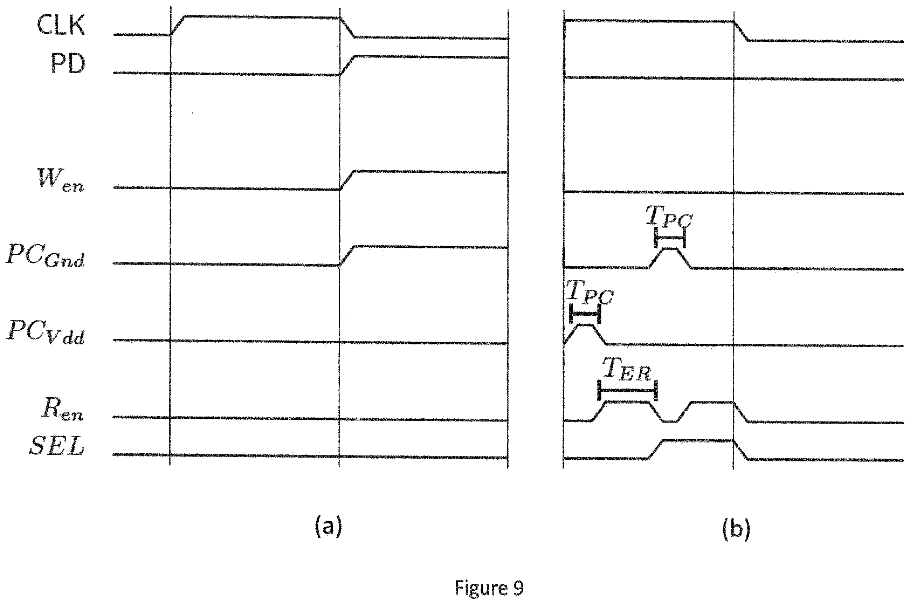

**Figure 9** shows an exemplary way of generating the control signals Wₑₙ, PC_{GND}, PC_{Vdd}, Rₑₙ and SEL for the non-volatile storage circuit 100. In this example, the control signals are generated using a combination of the system clock signal CLK and the PD signal. In particular, Figure 9a refers to the write phase and Figure 9b refers to the read phase.

In an initial state, all control signals are inactive, i.e. in a low state.

The PD signal may be low while power is being supplied. When the PD signal turns to a high state, it indicates that the entire circuitry in the SoC is going to be power gated. The powering-down may be done at a particular level of the CLK signal, e.g. low, and so the write phase may be triggered, i.e. the Wₑₙ and PC_{GND} control signals are activated based on the combined activity of the CLK and PD signals and the other control signals remain in the previous low state.

The read operation may instead be performed when the CLK signal is in a high state and the PD signal is in a low state. During the read phase, the supply voltage is enabled and the PC_{Vdd}, PC_{GND}, Rₑₙ and SEL signals are activated globally at system level, i.e. independently from the CLK signal.

Figure 9b also shows how sequential read has almost no delay penalty because the read evaluation is so fast that both read operations can be finished within a typical cycle time duration.

In another example, not shown in Figure 9, all control signals are generated independently from the CLK signal but still based on the PD signal. In other words, the controlling is performed at the system level globally, i.e. using a single design block such that the same signals are applied to all flip-flop circuits. With respect to the previous examples shown in Figure 9, this way of generating control signals can have a relatively greater area overhead. Conversely, the advantage of system-level control is that it can have better controllability in the presence of the process variations, because the control signals can be adjusted to counteract the process variation effect.

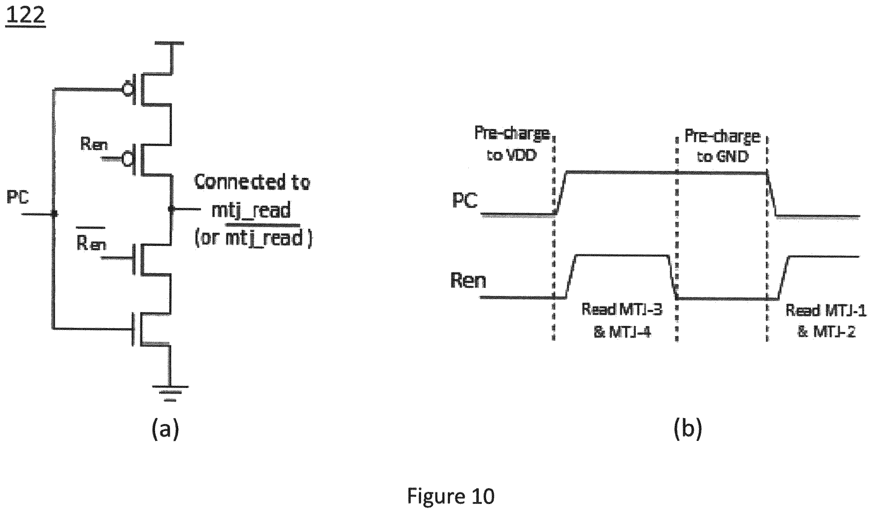

In the examples above, the read component requires four control signals, PC_{GND}, PC_{Vdd}, Rₑₙ and SEL. In one example, these can be reduced to two, a common control signal PC and Rₑₙ. **Figure 10a** shows an exemplary pre-charge component controlled by PC and Rₑₙ instead of PC_{GND} and PC_{Vdd} as shown in Figure 6. **Figure 10b** shows the control signals for the exemplary pre-charge component of Figure 10a.

Figure 10a shows, in particular, one part of the two identical parts of the pre-charge component 122. Unlike the one shown in Figure 6, this part comprises four transistors in a row, two NMOS and two PMOS. A first transistor is connected to ground, a second transistor is connected to the first transistor and to a third transistor, which in turn is connected to a fourth transistor, which is connected to a supply voltage source. The output node is located between the second and third transistors. The first and second transistors are NMOS and the third and fourth transistors are PMOS. The first and fourth transistors are controlled by the common signal PC and are alternatively activated, and the third and fourth transistors are controlled by the read enable signal Rₑₙ and are both active low.

Further, both P4 and N4 transistors are controlled using the PC signal, and the first stabilizing element 126 is active low and the second stabilizing element 128 is active high. As shown in Figure 10b, depending on the Rₑₙ signal and on the PC signal, the output nodes can be pre-charged to V_{dd} and the lower pair of MTJs can then be read without interference, since P4 is on. Afterwards, the output nodes are pre-charged to ground and the upper pair of MTJs can be read without interference, since N4 is on. Furthermore, the two output nodes can be pre-charged to ground during the write operations (which is desirable as described earlier) by activating PC, as Rₑₙ is low during the write phase.

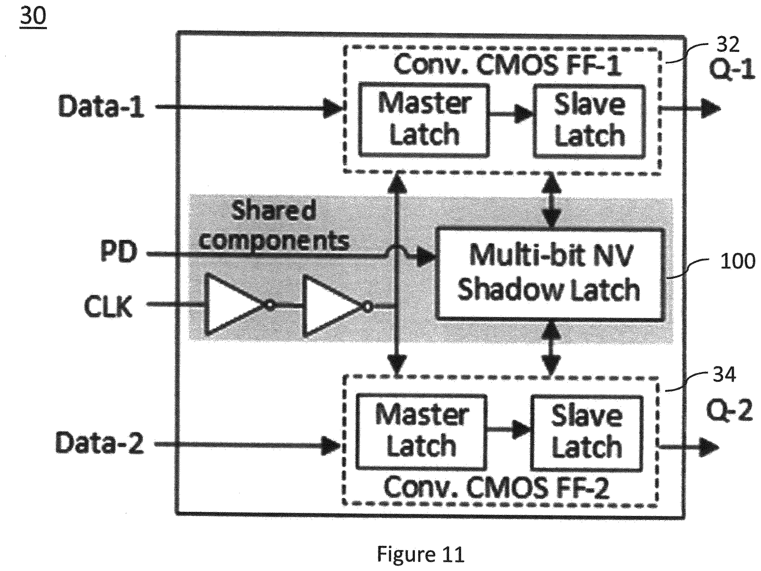

A combined architecture using CMOS flip-flops and a back-up based on the proposed two-bit non-volatile storage circuit can be obtained, as shown in **Figure 11****.** It can be seen that the clock buffers as well as the non-volatile components are shared between the two conventional CMOS flip-flops. The data backup/restore can be accessed in the similar way as it is done for the standard single-bit shadow architecture. On the top of benefits discussed above, the multi-bit non-volatile shadow flip-flop 30 of Figure 10 further improves the clock network power due to reduction of clock buffers. The reason is that clock buffers are typically large in size, so that sharing them results in fewer clock sinks (i.e. less energy consumption) as well as a smaller area. In a nutshell, the overall efficiency of the design in terms of area and energy is improved with this combined architecture.

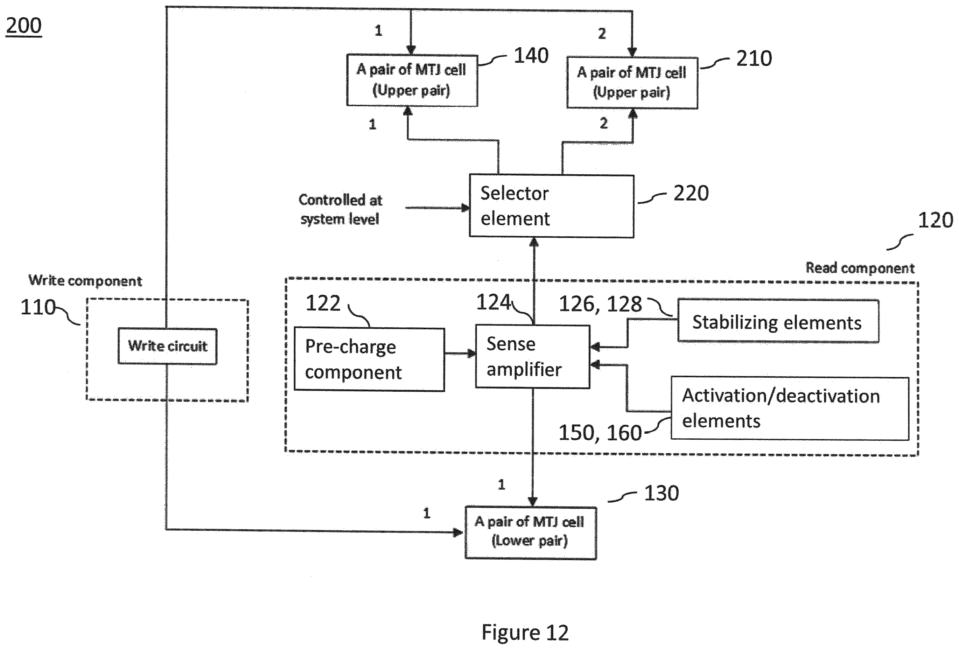

There is a possibility that more than two flip-flops can be placed adjacent in the SoC layout. In the proposed design, the number of storage bits can be easily scaled. **Figure 12** shows a schematic representation of a non-volatile storage circuit 200 for a three-bit non-volatile shadow flip-flop. In order to store a third bit, the non-volatile storage circuit 200 comprises a third pair of non-volatile memories 210. Accordingly, the write component 110 comprises a third part with two additional inverters for writing to the third pair of non-volatile memories 210 and is, thus, configured to receive third data from a third flip-flop. First data, second data and third data are all simultaneously written to the pairs of MTJ cells.

A third activation/deactivation element is associated to the third pair of non-volatile memories 210 for reading the third data. The third pair of non-volatile memories 210 may exemplarily be located on the same side of the sense amplifier 124 as the second pair of non-volatile memories 140. Thus, the non-volatile storage circuit 200 comprises a selector element 220 to switch from one upper pair to the other upper pair when reading. For example, the selector element 220 may comprise at least one multiplexer. Exemplarily, the transmission gates T1 and T2 may be replaced with multiplexers to increase the number of ports. The selector element 220 is controlled at system level.

The read component 120 reads the first data, and then, once the second pair of non-volatile memories 140 is selected by the selector element 220, the second data. Finally, the selector element 220 selects the third pair of non-volatile memories 210 and the read component reads the third data. In each of these three read operations, the read data are sent to the respective flip-flop.

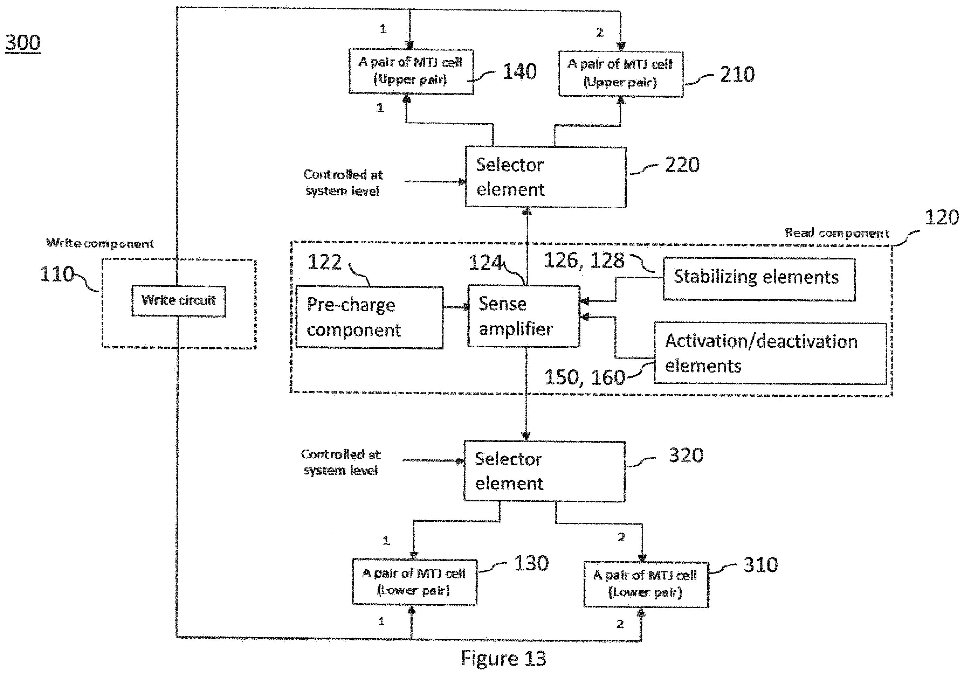

**Figure 13** shows a schematic representation of a non-volatile storage circuit 300 for a four-bit non-volatile shadow flip-flop. With respect to Figure 11, there is an additional, i.e. a fourth, pair of non-volatile memories 310 for storing the fourth bit of a fourth flip-flop, which is on the same side as the first pair of non-volatile memories 130. A fourth activation/deactivation element is associated to the fourth pair of non-volatile memories 310 for reading the fourth data. The non-volatile storage circuit 300 comprises a second selector element 320 for switching from one lower pair to the other lower pair when reading. The write component 110 must further comprise a fourth part for writing the fourth bit.

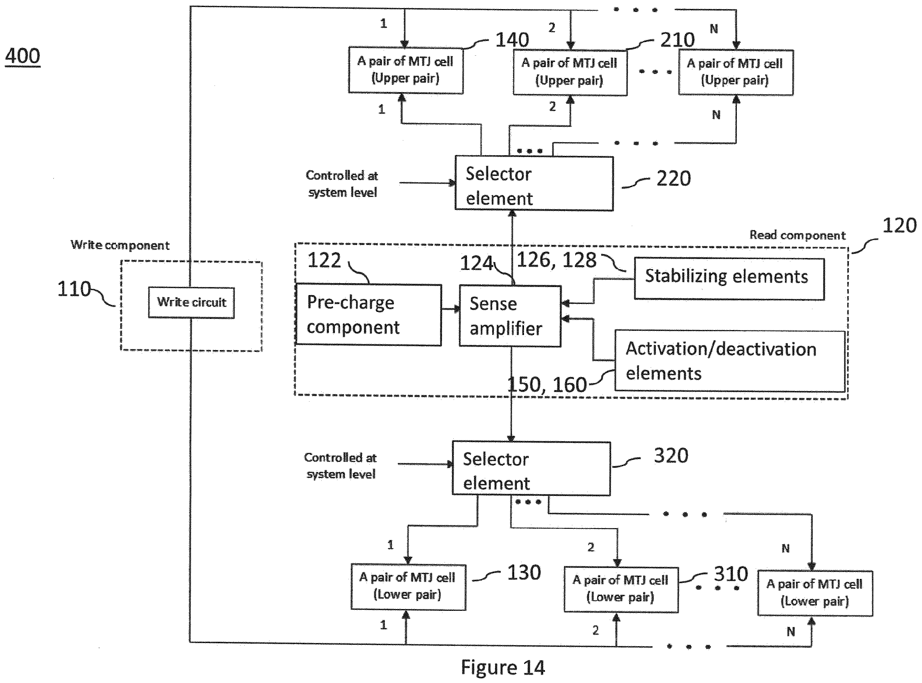

**Figure 14** shows a schematic representation of a non-volatile storage circuit 400 for an N-bit non-volatile shadow flip-flop. The design can be naturally generalized to N bits (N being a natural number greater than 0), wherein the write component 110 comprises N parts, each including two tristate inverters, for simultaneously writing N bits into N pairs of non-volatile memories. The N pairs of non-volatile memories are divided in Nᵤₚₚₑᵣ upper pairs and N_{lower} lower pairs, with Nᵤₚₚₑᵣ and N_{lower} non-zero natural numbers such that Nᵤₚₚₑᵣ + N_{lower} = N. The selector elements 210 and 310 allow switching among Nᵤₚₚₑᵣ pairs of non-volatile memories and N_{lower} pairs of non-volatile memories, respectively. The read component 120 of the non-volatile storage circuit 400 comprises N activation/deactivation elements, while the sense amplifier 124, the pre-charge component 122 and the stabilizing elements 126, 128 are the same as in the two-bit case.

In the following, experimental results showing the efficiency of the proposed design are presented. Specifically, a circuit-level analysis as well as a system-level evaluation are performed.

### Circuit-level analysis

The circuit-level simulations were performed using *Cadence Spectre Simulator* tool. For that, the MTJ model proposed in Mejdoubi et al. "A compact model of precessional spin-transfer switching for MTJ with a perpendicular polarseer", MIEL, 2012 has been employed. For for CMOS components the TSMC 40 nm low-power SPICE models have been used. The details of the design parameters of the simulations are depicted in Table I. For process corner analysis, ± 3σ variations for the product of Resistance-Area (RA), Tunnelling Magneto Resistance (TMR) value and switching current have been considered.

**Table I**

| **Parameters** | **Value** |
|---|---|
| V_{dd} (Supply Voltage), Operating Temperature | 1.1 V, 27°C |
| MTJ radius | 20 nm |
| Free/Oxide layer thickness | 1.84/1.48 nm |
| Resistance-Area | 1.26 Ωµm² |
| Tunneling Magneto Resistance @0V | 123% |
| Critical current | 37 uA |
| Switching current | 70 uA |
| AP/P resistance | 11 kΩ / 5 kΩ |

For circuit-level analysis, netlists for the proposed two-bit latch schematic (Figures 4-6) as well as for the standard design (Figure 2) have been developed. For the standard latch design, the read component was designed based on the pre-charge sensing circuit of W. Mao et al. "Design considerations and strategies for high-reliable STT-MRAM" Microelectronics Reliability, 51(9):1454-1458, 2011. Tristate inverters were used as write component and a set of transmission gates were employed to isolate the read components during the write operation. Using SPICE simulations, the design parameters such as latency and energy consumption for both store and restore operations were extracted. The design parameters for the proposed two-bit latch as well as for the two standard one-bit latch design for three corner cases are shown in Table II.

**Table II**

| | Two standard one-bit latch | | | Proposed two-bit latch | | |
|---|---|---|---|---|---|---|
| | worst | typical | best | worst | typical | best |
| Read energy [fJ] | 6.348 | 5.650 | 4.916 | 4.799 | 4.587 | 4.327 |
| Read delay [ps] | 310 | 187 | 127 | 600 | 360 | 228 |
| Leakage [pW] | 4998 | 1565 | 424 | 4960 | 1528 | 394 |
| # of transistors | 22 | | | 16 | | |
| Area [µm²] | 5.635 | | | 3.696 | | |

For fair comparison, an equal number of storage bits for both designs has been considered. Therefore, all single-bit standard latch results were multiplied by a factor of two, except for the layout area (as explained below). As shown in the table, the proposed design has better read active energy efficiency (around 19%) than that of the standard design. This is due to fact that the read controlling mechanism as well as the pre-charge circuitry are designed in such a way that it leads to a fewer number of transitions.

The read latency is significantly different for the proposed and standard designs as shown in Table II. The single bit read for the proposed design is almost similar to that of the standard design. But, since in the proposed circuitry each bit is read sequentially, its read latency is approximately twice of the standard design. Nevertheless, the read phase can be easily completed within a clock cycle time duration as read operations are exceptionally fast, as opposed to the write operations. Additionally, it is demonstrated that the wake-up time for a STT-based embedded microcontroller can be as high as 120 ns (N. Sakintura, et al. A 90nm 20mhz fully nonvolatile microcontroller for standby-power-critical applications. In ISSCC, pages 184-1S5, 2014). This is mainly due to the stabling period of the power signal. The total read delay of the proposed design is significantly lower than the system wake-up delay. On the other hand, both designs have employed the same writing methodology, so they have similar write energy and latency values, that is around 104 fJ and 2 ns for the worst case, respectively. As described earlier, the write mechanism is kept reliable in that the circuit organization of the proposed design does not lead to any sneaky current flow.

Another important design metric is the area, where the proposed design has shown considerable improvement over the conventional single-bit non-volatile latch design, since the read component is shared between the two flip-flops. The number of transistors (excluding write components here) used for the proposed two-bit design is only 16 in comparison to 22 for two bits in the standard design. Accordingly, compared to a single-bit standard design, only five additional transistors are added in the proposed multi-bit latch. For accurate area evaluations, layouts for both proposed design as well as the standard design were drawn using *Cadence Virtuoso* tool.

For the area calculation of the standard design, the minimum spacing margin has been further added to twice the width of the actual layout block. At cell-level, the area of the proposed design is improved by around 34% compared to the standard design for two bits. It is worth mentioning that in general the conventional CMOS multi-bit layout covers two rows during the placement and a similar layout can be easily generated for the proposed design as well.

### System-level evaluation

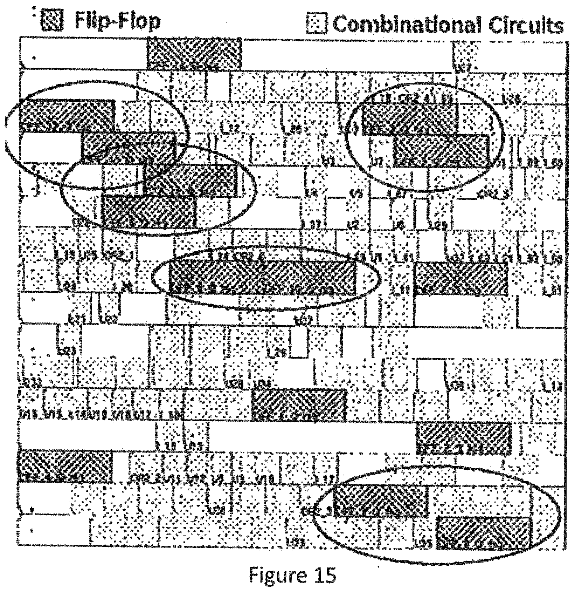

For the system-level analysis, the *Synopsys Design* compiler has been used for synthesis and the *Cadence Encounter* tool has been used for the physical design activities such as floorplan, placement and routing. For system-level evaluation, several benchmark circuits have been considered and synthesis, floorplan and placement on their RTL netlists have been performed. In this process, the default mode of option for the design constraints has been mostly adopted. Moreover, it has been assumed that each sequential element in the benchmark circuit requires a back-up and, therefore, the existing flip-flops were replaced with the shadow flip-flop architecture. After the placement, the flip-flops sufficiently close to each other to be replaced by the proposed two-bit non-volatile flip-flop design have been selected. The limit of closeness of two flip-flops is decided in such a way that there should not be any timing penalties. Therefore, only cases where the two flip-flops are apart less than the twice of the width of the non-volatile component of the standard single-bit design (i.e. lower than 3,35 pm) have been considered. To illustrate such flip-flop cases, a floorplan design for a s344 circuit is shown in **Figure 15****.** The identification of such neighboring flip-flops in the layout is done using a script that is executed over the *Design Exchange Forma* (DEF) file. Note that, in this analysis, those flip-flops that cannot be merged were replaced with standard single-bit non-volatile flip-flops.

The system-level analysis results for various benchmark circuits are shown in Table III. Here, the improvement is with respect to the case where all flip-flops are replaced with the standard single-bit non-volatile flip-flop design. As shown, both area as well as read energy improvements are increasing with the increase in the number of two-bit non-volatile flip-flop designs. The average area and read energy improvements for all benchmark circuits are 26% and 14%, respectively.

**Table III**

| | | | Back-up using one-bit non-volatile shadow latch | | Back-up using proposed two-bit non-volatile shadow latch | | Improvement | |
|---|---|---|---|---|---|---|---|---|
| Benchmark | Total number of flip-flops | Number of two-bit non-volatile shadow flip-flops | Area [µm²] | Read energy [fJ] | Area [mm²] | Read energy [fJ] | Area [%] | Read energy [%] |
| s344 | 15 | 5 | 42.255 | 42.375 | 32.565 | 37.06 | 22.93% | 12.54% |
| s838 | 32 | 12 | 90.144 | 90.4 | 66.888 | 77.644 | 25.80% | 14.11% |
| s1423 | 74 | 23 | 208.458 | 209.05 | 163.884 | 184.601 | 21.38% | 11.70% |
| s5378 | 176 | 64 | 495.792 | 497.2 | 371.76 | 429.168 | 25.02% | 13.68% |
| s13207 | 627 | 259 | 1766.259 | 1771.275 | 1264, 317 | 1495.958 | 28.42% | 15.54% |
| s38584 | 1424 | 473 | 4011.408 | 4022.8 | 3094.734 | 3520.001 | 22.85% | 12.50% |
| s35932 | 1728 | 472 | 4867.776 | 4881.6 | 3953.04 | 4379.864 | 18.79% | 10.28% |
| 614 | 215 | 90 | 605.655 | 607.375 | 431.235 | 511.705 | 28.80% | 15.75% |
| 615 | 416 | 189 | 1171.872 | 1175.2 | 805.59 | 974.293 | 31.26% | 17.10% |
| b17 | 1317 | 542 | 3709.989 | 3720.525 | 2659.593 | 3144.379 | 28.31% | 15.49% |
| 618 | 3020 | 1260 | 8507.34 | 8531.5 | 6065.46 | 7192.12 | 28.70% | 15.70% |
| b19 | 6042 | 2530 | 17020.314 | 17068.65 | 12117.174 | 14379.26 | 28.81% | 15.76% |
| or1200 | 2887 | 1269 | 8132.679 | 8155.775 | 5673.357 | 6806.828 | 30.24% | 16.54% |

## Claims

1. A non-volatile storage circuit (100) for storing first data from a first flip-flop circuit (32) and second data from a second flip-flop circuit (34) when power gating, the non-volatile storage circuit (100) comprising:
a write component (110);
two output nodes;
a read component (120) comprising a pre-charge component (122) connected to the two output nodes; and
a first pair of non-volatile memories (130) and a second pair of non-volatile memories (140) connected to the read component (120) and to the write component (110);
wherein:
the non-volatile storage circuit (100) is connectable to the first flip-flop circuit (32) and the second flip-flop circuit (34);
at power-down of the first flip-flop circuit (32) and the second flip-flop circuit (34), the write component (110) is configured to simultaneously write the first data to the first pair of non-volatile memories (130) and the second data to the second pair of non-volatile memories (140);
at power-up of the first flip-flop circuit (32) and the second flip-flop circuit (34), the read component (120) is configured to sequentially read the first data from the first pair of non-volatile memories (130) and the second data from the second pair of non-volatile memories (140);
reading the first data from the first pair of non-volatile memories (130) being a first read and reading the second data from the second pair of non-volatile memories (140) being a second read;
the pre-charge component (122) is configured to equalize the two output nodes at supply voltage during the first read and at ground voltage during the second read;
the non-volatile storage circuit (100) is configured such that
the first pair of non-volatile memories (130) is connected to ground during the first read and
the second pair of non-volatile memories (140) is connected to a supply voltage source during the second read;
and further wherein:
the read component (120) further comprises a sense amplifier (124) including a first inverter and a second inverter, each inverter comprising two transistors, wherein each output node is connected to an output of a corresponding inverter;
the read component (120) further comprises a first stabilizing element (126) interposed between the sense amplifier (124) and the first pair of non-volatile memories (130) and a second stabilizing element (128) interposed between the sense amplifier (124) and the second pair of non-volatile memories (140);
the first stabilizing element (126) is connected to the source terminals of a first transistor in the first inverter and a first transistor in the second inverter, the first transistors being each connected to a corresponding one of the non-volatile memories of the first pair of non-volatile memories (130), and
the first stabilizing element (126) is configured to equalize the source terminals of the first transistors while the second data are read;
the second stabilizing element (128) is connected to the source terminals of a second transistor in the first inverter and a second transistor in the second inverter, the second transistors being each connected to a corresponding one of the non-volatile memories of the second pair of non-volatile memories (140), and
the second stabilizing element (128) is configured to equalize the source terminals of the second transistors while the first data are read.

2. The non-volatile storage circuit (100) of claim 1, wherein the pre-charge component (122) and the first and second stabilizing elements (126, 128) are configured to be controlled by a common signal.

3. The non-volatile storage circuit (200, 300, 400) of any one of the preceding claims for further storing additional data from one or more additional flip-flop circuits, the non-volatile storage circuit further comprising one or more additional pairs of non-volatile memories (210, 310) and at least one selector element (220, 320), wherein:
the write component (110) is connected to the additional pair(s) of non-volatile memories (210, 310);
at power-down of the flip-flop circuits, the write component (110) is further configured to write additional data in the additional pair(s) of non-volatile memories (210, 310) simultaneously to the first data and the second data;
the read component (120) is connected to at least two pairs of non-volatile memories via the at least one selector element (220, 320); and
at power-up of the flip-flop circuits, the read component (120) is further configured to sequentially read the additional data.

4. A multi-bit non-volatile memory (30) comprising:
a non-volatile storage circuit (100) according to claim 1 or 2; the first flip-flop circuit (32) and the second flip-flop circuit (34) connected to the read component (120) and to the write component (110);
wherein:
at power-down of the multi-bit non-volatile memory (30), the first flip-flop circuit (32) is configured to transmit the first data to the write component (110) and the second flip-flop circuit (34) is configured to transmit the second data to the write component (110); and
at power-up of the multi-bit non-volatile memory (30), the first flip-flop circuit (32) is configured to receive the first data from the read component (120) and the second flip-flop circuit (34) is configured to receive the second data from the read component (120).

5. The multi-bit non-volatile memory (30) of claim 4, further comprising at least one clock buffer, wherein the at least one clock buffer is shared between the first flip-flop circuit (32) and the second flip-flop circuit (34).

6. A multi-bit non-volatile memory comprising:
a non-volatile storage circuit (200, 300, 400) according to claim 3;
a plurality of flip-flop circuits connected to the read component (120) and to the write component (110), wherein the number of flip-flop circuits corresponds to the total number of pairs of non-volatile memories;
wherein:
at power-down of the multi-bit non-volatile memory, each flip-flop circuit is configured to transmit respective data to the write component (110); and
at power-up of the multi-bit non-volatile memory, each flip-flop circuit is configured to receive respective data from the read component (120).

7. A microprocessor comprising one or more multi-bit non-volatile memories according to any one of claims 4 to 6.

8. A method for operating a non-volatile storage circuit (100) for storing first data from a first flip-flop circuit (32) and second data from a second flip-flop circuit (34) when power gating, the non-volatile storage circuit (100) comprising:
a write component (110);
two output nodes;
a read component (120) comprising a pre-charge component (122) connected to the two output nodes; and
a first pair of non-volatile memories (130) and a second pair of non-volatile memories (140) connected to the read component (120) and to the write component (110);
the method comprising:
at power-down of the first flip-flop circuit (32) and the second flip-flop circuit (34), simultaneously writing, by the write component (110), the first data to the first pair of non-volatile memories (130) and the second data to the second pair of non-volatile memories (140); and
at power-up of the first flip-flop circuit (32) and the second flip-flop circuit (34), sequentially reading, by the read component (120), the first data from the first pair of non-volatile memories (130) and the second data from the second pair of non-volatile memories (140).
when reading the first data from the first pair of non-volatile memories (130):
equalizing, by the pre-charge component (122), the two output nodes at supply voltage; and
connecting the first pair of non-volatile memories (130) to ground;
when reading the second data from the second pair of non-volatile memories (140):
equalizing, by the pre-charge component (122), the two output nodes at ground voltage; and
connecting the second pair of non-volatile memories (140) to a supply voltage source;
and wherein:
the read component (120) comprises a sense amplifier (124) including a first inverter and a second inverter, each inverter comprising two transistors, wherein each output node is connected to an output of a corresponding inverter;
the read component (120) further comprises a first stabilizing element (126) interposed between the sense amplifier (124) and the first pair of non-volatile memories (130) and a second stabilizing element (128) interposed between the sense amplifier (124) and the second pair of non-volatile memories (140);
the first stabilizing element (126) is connected to the source terminals of a first transistor in the first inverter and a first transistor in the second inverter, the first transistors being each connected to a corresponding one of the non-volatile memories of the first pair of non-volatile memories (130);
the second stabilizing element (128) is connected to the source terminals of a second transistor in the first inverter and a second transistor in the second inverter, the second transistors being each connected to a corresponding one of the non-volatile memories of the second pair of non-volatile memories (140); and
the method further comprises:
equalizing, by the first stabilizing element (126), the source terminals of the first transistors when reading the second data; and
equalizing, by the second stabilizing element (128), the source terminals of the second transistors when reading the first data.

9. The method of claim 8, further comprising controlling with a common signal the pre-charge component (122) and the first and second stabilizing elements (126, 128).

10. The method of claim 8 or 9, wherein the non-volatile storage circuit (200, 300, 400) is further for storing additional data from one or more additional flip-flop circuits, wherein:
the non-volatile storage circuit (200, 300, 400) further comprises one or more additional pairs of non-volatile memories (210, 310) and at least one selector element (220, 320), the write component (110) is connected to the additional pair(s) of non-volatile memories (210, 310);
the read component (120) is connected to at least two pairs of non-volatile memories via the at least one selector element (220, 320); and
the method further comprises:
at power-down of the flip-flop circuits, writing, by the write component (110), the additional data in the additional pair(s) of non-volatile memories (210, 310) simultaneously to the first data and the second data;
and
at power-up of the flip-flop circuits, reading, by the read component (120), the additional data sequentially with the first data and the second data.

11. The method of claim 8 or 9, further comprising:
at power-down of the first flip-flop circuit (32) and the second flip-flop circuit (34):
transmitting, by the first flip-flop circuit (32), the first data to the write component (110) and transmitting, by the second flip-flop circuit (34), the second data to the write component (110); and
at power-up of the first flip-flop circuit (32) and the second flip-flop circuit (34):
receiving, by the first flip-flop circuit (32), the first data from the read component (120) and receiving, by the second flip-flop circuit (34), the second data from the read component (120).

## Patentansprüche

1. Eine nicht-flüchtige Speicherschaltung (100) zum Speichern von ersten Daten von einer ersten Flip-Flop-Schaltung (32) und zweiten Daten von einer zweiten Flip-Flop-Schaltung (34) beim *Power-Gating*, wobei die nicht-flüchtige Speicherschaltung (100) Folgendes umfasst:
eine Schreibkomponente (110);
zwei Ausgangsknoten;
eine Lesekomponente (120), die eine mit den beiden Ausgangsknoten verbundene Vorladekomponente (122) umfasst; und
ein erstes Paar nicht-flüchtiger Speicher (130) und ein zweites Paar nicht-flüchtiger Speicher (140), die mit der Lesekomponente (120) und mit der Schreibkomponente (110) verbunden sind;
wobei:
die nicht-flüchtige Speicherschaltung (100) verbindbar ist mit der ersten Flip-Flop-Schaltung (32) und der zweiten Flip-Flop-Schaltung (34);
beim Abschalten der ersten Flip-Flop-Schaltung (32) und der zweiten Flip-Flop-Schaltung (34) die Schreibkomponente (110) so konfiguriert ist, dass sie gleichzeitig die ersten Daten in das erste Paar nicht-flüchtiger Speicher (130) und die zweiten Daten in das zweite Paar nicht-flüchtiger Speicher (140) schreibt;
beim Einschalten der ersten Flip-Flop-Schaltung (32) und der zweiten Flip-Flop-Schaltung (34) die Lesekomponente (120) so konfiguriert ist, dass sie sequentiell die ersten Daten aus dem ersten Paar nicht-flüchtiger Speicher (130) und die zweiten Daten aus dem zweiten Paar nicht-flüchtiger Speicher (140) liest;
das Lesen der ersten Daten aus dem ersten Paar nicht-flüchtiger Speicher (130) ein erstes Lesen ist, und wobei das Lesen der zweiten Daten aus dem zweiten Paar nicht-flüchtiger Speicher (140) ein zweites Lesen ist;
die Vorladekomponente (122) so konfiguriert ist, dass sie die beiden Ausgangsknoten während des ersten Lesens auf Versorgungsspannung und während des zweiten Lesens auf Erdungsspannung ausgleicht;
die nicht-flüchtige Speicherschaltung (100) so konfiguriert ist, dass
das erste Paar nicht-flüchtiger Speicher (130) während des ersten Lesens mit Masse verbunden ist und dass
das zweite Paar nicht-flüchtiger Speicher (140) während des zweiten Lesevorgangs an eine Versorgungsspannungsquelle angeschlossen ist;
und wobei ferner:
die Lesekomponente (120) ferner einen Leseverstärker (*sense amplifier*) (124) umfasst, der einen ersten Inverter und einen zweiten Inverter beinhaltet, wobei jeder Inverter zwei Transistoren umfasst, wobei jeder Ausgangsknoten mit einem Ausgang eines entsprechenden Inverters verbunden ist;
die Lesekomponente (120) ferner ein erstes Stabilisierungselement (126), das zwischen dem Leseverstärker (124) und dem ersten Paar nicht-flüchtiger Speicher (130) angeordnet ist, und ein zweites Stabilisierungselement (128) umfasst, das zwischen dem Leseverstärker (124) und dem zweiten Paar nicht-flüchtiger Speicher (140) angeordnet ist;
das erste Stabilisierungselement (126) mit den Source-Anschlüssen eines ersten Transistors im ersten Inverter und eines ersten Transistors im zweiten Inverter verbunden ist, wobei die ersten Transistoren jeweils mit einem entsprechenden von einem der nicht-flüchtigen Speicher des ersten Paars nicht-flüchtiger Speicher (130) verbunden sind, und wobei ferner
das erste Stabilisierungselement (126) so konfiguriert ist, dass es die Source-Anschlüsse der ersten Transistoren ausgleicht, während die zweiten Daten gelesen werden;
das zweite Stabilisierungselement (128) mit den Source-Anschlüssen eines zweiten Transistors im ersten Inverter und eines zweiten Transistors im zweiten Inverter verbunden ist, wobei die zweiten Transistoren jeweils mit einem entsprechenden von einem der nicht-flüchtigen Speicher des zweiten Paars nicht-flüchtiger Speicher (140) verbunden sind, und wobei ferner
das zweite Stabilisierungselement (128) so konfiguriert ist, dass es die Source-Anschlüsse der zweiten Transistoren ausgleicht, während die ersten Daten gelesen werden.

2. Die nicht-flüchtige Speicherschaltung (100) nach Anspruch 1, wobei die Vorladekomponente (122) und das erste und zweite Stabilisierungselement (126, 128) so konfiguriert sind, dass sie durch ein gemeinsames Signal gesteuert werden.

3. Die nicht-flüchtige Speicherschaltung (200, 300, 400) nach irgendeinem der vorhergehenden Ansprüche zur weiteren Speicherung zusätzlicher Daten von einer oder mehreren zusätzlichen Flip-Flop-Schaltungen, wobei die nicht-flüchtige Speicherschaltung ferner ein oder mehrere zusätzliche Paare nicht-flüchtiger Speicher (210, 310) und mindestens ein Auswahl- bzw. Selektor-Element (220, 320) umfasst, wobei:
die Schreibkomponente (110) mit dem (den) zusätzlichen Paar(en) nicht-flüchtiger Speicher (210, 310) verbunden ist;
beim Abschalten der Flip-Flop-Schaltungen die Schreibkomponente (110) ferner konfiguriert ist, um zusätzliche Daten in das/die zusätzliche(n) Paar(e) nicht-flüchtiger Speicher (210, 310) gleichzeitig zu den ersten Daten und den zweiten Daten schreiben;
die Lesekomponente (120) mit mindestens zwei Paaren nicht-flüchtiger Speicher über das mindestens eine Selektor-Element (220, 320) verbunden ist; und wobei
beim Einschalten der Flip-Flop-Schaltungen die Lesekomponente (120) ferner konfiguriert wird, um die zusätzlichen Daten sequentiell zu lesen.

4. Ein nicht-flüchtiger Mehrbit-Speicher (30), der Folgendes umfasst:
eine nicht-flüchtige Speicherschaltung (100) nach Anspruch 1 oder 2;
wobei die erste Flip-Flop-Schaltung (32) und die zweite Flip-Flop-Schaltung (34) mit der Lesekomponente (120) und der Schreibkomponente (110) verbunden sind;
wobei:
beim Abschalten des nicht-flüchtigen Mehrbit-Speichers (30) die erste Flip-Flop-Schaltung (32) so konfiguriert ist, dass sie die ersten Daten an die Schreibkomponente (110) überträgt, und die zweite Flip-Flop-Schaltung (34) so konfiguriert ist, dass sie die zweiten Daten an die Schreibkomponente (110) überträgt; und wobei
beim Einschalten des nicht-flüchtigen Mehrbit-Speichers (30) die erste Flip-Flop-Schaltung (32) konfiguriert ist, um die ersten Daten von der Lesekomponente (120) zu empfangen, und die zweite Flip-Flop-Schaltung (34) konfiguriert ist, um die zweiten Daten von der Lesekomponente (120) zu empfangen.

5. Der nicht-flüchtige Mehrbit-Speicher (30) nach Anspruch 4, ferner umfassend mindestens einen Taktpuffer, wobei der mindestens eine Taktpuffer von der ersten Flip-Flop-Schaltung (32) und der zweiten Flip-Flop-Schaltung (34) gemeinsam genutzt wird.

6. Ein nicht-flüchtiger Mehrbit-Speicher, der Folgendes umfasst:
eine nicht-flüchtige Speicherschaltung (200, 300, 400) nach Anspruch 3;
eine Vielzahl von Flip-Flop-Schaltungen, die mit der Lesekomponente (120) und der Schreibkomponente (110) verbunden sind, wobei die Anzahl der Flip-Flop-Schaltungen der Gesamtzahl der Paare nicht-flüchtiger Speicher entspricht;
wobei
beim Abschalten des nicht-flüchtigen Mehrbit-Speichers jede Flip-Flop-Schaltung so konfiguriert ist, dass sie entsprechende Daten an die Schreibkomponente (110) überträgt; und wobei
beim Einschalten des nicht-flüchtigen Multibit-Speichers jede Flip-Flop-Schaltung so konfiguriert ist, dass sie die entsprechenden Daten von der Lesekomponente empfängt (120).

7. Ein Mikroprozessor, der einen oder mehrere nicht-flüchtige Multibit-Speicher nach irgendeinem der Ansprüche von 4 bis 6 umfasst.

8. Ein Verfahren zum Betreiben einer nicht-flüchtigen Speicherschaltung (100) zum Speichern von ersten Daten von einer ersten Flip-Flop-Schaltung (32) und zweiten Daten von einer zweiten Flip-Flop-Schaltung (34) beim *Power-Gating*, wobei die nicht-flüchtige Speicherschaltung (100) Folgendes umfasst:
eine Schreibkomponente (110);
zwei Ausgangsknoten;
eine Lesekomponente (120), die eine mit den beiden Ausgangsknoten verbundene Vorladekomponente (122) umfasst; und
ein erstes Paar nicht-flüchtiger Speicher (130) und ein zweites Paar nicht-flüchtiger Speicher (140), die mit der Lesekomponente (120) und mit der Schreibkomponente (110) verbunden sind;
wobei das Verfahren Folgendes umfasst:
beim Abschalten der ersten Flip-Flop-Schaltung (32) und der zweiten Flip-Flop-Schaltung (34), gleichzeitig Schreiben, durch die Schreibkomponente (110), der ersten Daten in das erste Paar nicht-flüchtiger Speicher (130) und der zweiten Daten in das zweite Paar nicht-flüchtiger Speicher (140); und
beim Einschalten der ersten Flip-Flop-Schaltung (32) und der zweiten Flip-Flop-Schaltung (34), sequentiell Lesen, durch die Lesekomponente (120), der ersten Daten aus dem ersten Paar nicht-flüchtiger Speicher (130) und der zweiten Daten aus dem zweiten Paar nicht-flüchtiger Speicher (140);
beim Lesen der ersten Daten aus dem ersten Paar nicht-flüchtiger Speicher (130):
Ausgleichen, durch die Vorladekomponente (122), der beiden Ausgangsknoten bei Versorgungsspannung; und
Verbinden des ersten Paares nicht-flüchtiger Speicher (130) mit Masse;
beim Lesen der zweiten Daten aus dem zweiten Paar nicht-flüchtiger Speicher (140):
Ausgleichen, durch die Vorladekomponente (122), der beiden Ausgangsknoten bei Massespannung; und
Verbinden des zweiten Paares nicht-flüchtiger Speicher (140) an eine Versorgungsspannungsquelle;
und wobei:
die Lesekomponente (120) einen Leseverstärker (*sense amplifier*) (124) umfasst, der einen ersten Inverter und einen zweiten Inverter beinhaltet, wobei jeder Inverter zwei Transistoren umfasst, wobei jeder Ausgangsknoten mit einem Ausgang eines entsprechenden Inverters verbunden ist;
die Lesekomponente (120) ferner ein erstes Stabilisierungselement (126), das zwischen dem Leseverstärker (124) und dem ersten Paar nicht-flüchtiger Speicher (130) angeordnet ist, und ein zweites Stabilisierungselement (128) umfasst, das zwischen dem Leseverstärker (124) und dem zweiten Paar nicht-flüchtiger Speicher (140) angeordnet ist;
das erste Stabilisierungselement (126) mit den Source-Anschlüssen eines ersten Transistors im ersten Inverter und eines ersten Transistors im zweiten Inverter verbunden ist, wobei die ersten Transistoren jeweils mit einem entsprechenden von einem der nicht-flüchtigen Speicher des ersten Paars nicht-flüchtiger Speicher (130) verbunden sind;
das zweite Stabilisierungselement (128) mit den Source-Anschlüssen eines zweiten Transistors im ersten Inverter und eines zweiten Transistors im zweiten Inverter verbunden ist, wobei die zweiten Transistoren jeweils mit einem entsprechenden von einem der nicht-flüchtigen Speicher des zweiten Paars nicht-flüchtiger Speicher (140) verbunden sind; und
wobei das Verfahren ferner Folgendes umfasst:
Ausgleichen, durch das erste Stabilisierungselement (126), der Source-Anschlüsse der ersten Transistoren, beim Lesen der zweiten Daten; und
Ausgleichen, durch das zweite Stabilisierungselement (128), der Source-Anschlüsse der zweiten Transistoren, beim Lesen der ersten Daten.

9. Das Verfahren nach Anspruch 8, ferner umfassend das Steuern, durch ein gemeinsames Signal, der Vorladekomponente (122) und des ersten und zweiten Stabilisierungselements (126, 128).

10. Das Verfahren nach Anspruch 8 oder 9, wobei die nicht-flüchtige Speicherschaltung (200, 300, 400) ferner zum Speichern zusätzlicher Daten von einer oder mehreren zusätzlichen Flip-Flop-Schaltungen dient, wobei:
die nicht-flüchtige Speicherschaltung (200, 300, 400) ferner ein oder mehrere zusätzliche Paare nicht-flüchtiger Speicher (210, 310) und mindestens ein Selektor-Element (220, 320) umfasst, wobei die Schreibkomponente (110) mit dem/den zusätzlichen Paar(en) nicht-flüchtiger Speicher (210, 310) verbunden ist;
die Lesekomponente (120) über das mindestens eine Selektor-Element (220, 320) mit mindestens zwei Paaren nicht-flüchtiger Speicher verbunden ist; und wobei das Verfahren ferner Folgendes umfasst:
beim Abschalten der Flip-Flop-Schaltungen, Schreiben, durch die Schreibkomponente (110), der zusätzlichen Daten in das/die zusätzliche(n) Paar(e) nicht-flüchtiger Speicher (210, 310) gleichzeitig zu den ersten Daten und den zweiten Daten; und
beim Einschalten der Flip-Flop-Schaltungen, Lesen, durch die Lesekomponente (120), der zusätzlichen Daten sequentiell mit den ersten Daten und den zweiten Daten.

11. Das Verfahren nach Anspruch 8 oder 9, ferner umfassend:
beim Ausschalten der ersten Flip-Flop-Schaltung (32) und der zweiten Flip-Flop-Schaltung (34):
Übertragen, durch die erste Flip-Flop-Schaltung (32), der ersten Daten an die Schreibkomponente (110) und
Übertragen, durch die zweite Flip-Flop-Schaltung (34), der zweiten Daten an die Schreibkomponente (110); und
beim Einschalten der ersten Flip-Flop-Schaltung (32) und der zweiten Flip-Flop-Schaltung (34):
Empfangen, durch die erste Flip-Flop-Schaltung (32), der ersten Daten von der Lesekomponente (120) und
Empfangen, durch die zweite Flip-Flop-Schaltung (34), der zweiten Daten von der Lesekomponente (120).

## Revendications

1. Un circuit de stockage non volatil (100) pour stocker des premières données provenant d'un premier circuit à bascule (32) et des deuxièmes données provenant d'un deuxième circuit à bascule (34) lors d'un portillonnage de puissance (*power gating*), le circuit de stockage non volatil (100) comprenant :
un composant d'écriture (110) ;
deux nœuds de sortie ;
un composant de lecture (120) comprenant un composant de précharge (122) connecté aux deux noeuds de sortie ; et
une première paire de mémoires non volatiles (130) et une deuxième paire de mémoires non volatiles (140) connectées au composant de lecture (120) et au composant d'écriture (110) ;
sachant que :
le circuit de stockage non volatil (100) peut être connecté au premier circuit à bascule (32) et au deuxième circuit à bascule (34) ;
à la mise hors tension du premier circuit à bascule (32) et du deuxième circuit à bascule (34), le composant d'écriture (110) est configuré pour écrire simultanément les premières données dans la première paire de mémoires non volatiles (130) et les deuxièmes données dans la deuxième paire de mémoires non volatiles (140) ;
à la mise sous tension du premier circuit à bascule (32) et du deuxième circuit à bascule (34), le composant de lecture (120) est configuré pour lire séquentiellement les premières données de la première paire de mémoires non volatiles (130) et les deuxièmes données de la deuxième paire de mémoires non volatiles (140) ;
la lecture des premières données de la première paire de mémoires non volatiles (130) étant une première lecture et la lecture des deuxièmes données de la deuxième paire de mémoires non volatiles (140) étant une deuxième lecture ;
le composant de précharge (122) est configuré pour égaliser les deux nœuds de sortie à la tension d'alimentation pendant la première lecture et à la tension de masse pendant la deuxième lecture ;
le circuit de stockage non volatil (100) est configuré de manière que
la première paire de mémoires non volatiles (130) est connectée à la terre pendant la première lecture et que
la deuxième paire de mémoires non volatiles (140) est connectée à une source de tension d'alimentation pendant la deuxième lecture ;
et sachant en outre que :
le composant de lecture (120) comprend en outre un amplificateur de détection (*sense amplifier*) (124) incluant un premier inverseur et un deuxième inverseur, chaque inverseur comprenant deux transistors, sachant que chaque nœud de sortie est connecté à une sortie d'un inverseur correspondant ;
le composant de lecture (120) comprend en outre un premier élément de stabilisation (126) interposé entre l'amplificateur de détection (124) et la première paire de mémoires non volatiles (130), et un deuxième élément de stabilisation (128) interposé entre l'amplificateur de détection (124) et la deuxième paire de mémoires non volatiles (140) ;
le premier élément de stabilisation (126) est connecté aux bornes de source d'un premier transistor dans le premier inverseur et d'un premier transistor dans le deuxième inverseur, les premiers transistors étant chacun connecté à une mémoire correspondante des mémoires non volatiles de la première paire de mémoires non volatiles (130), et que
le premier élément de stabilisation (126) est configuré pour égaliser les bornes de source des premiers transistors pendant la lecture des deuxièmes données ;
le deuxième élément de stabilisation (128) est connecté aux bornes de source d'un deuxième transistor dans le premier inverseur et d'un deuxième transistor dans le deuxième inverseur, les deuxièmes transistors étant chacun connecté à une mémoire correspondante de la deuxième paire de mémoires non volatiles (140), et que
le deuxième élément de stabilisation (128) est configuré pour égaliser les bornes de source des deuxièmes transistors pendant la lecture des premières données.

2. Le circuit de stockage non volatil (100) d'après la revendication 1, sachant que le composant de précharge (122) et les éléments de stabilisation premier et deuxième (126, 128) sont configurés pour être commandés par un signal commun.

3. Le circuit de stockage non volatil (200, 300, 400) d'après l'une quelconque des revendications précédentes pour stocker en outre des données supplémentaires provenant d'un ou plusieurs circuits à bascule supplémentaires, le circuit de stockage non volatil comprenant en outre une ou plusieurs paires supplémentaires de mémoires non volatiles (210, 310) et au moins un élément sélecteur (*selector element*) (220, 320), sachant que :
l'élément d'écriture (110) est connecté à la ou aux paires supplémentaires de mémoires non volatiles (210, 310) ;
à la mise hors tension des circuits à bascule, le composant d'écriture (110) est en outre configuré pour écrire des données supplémentaires dans la ou les paires supplémentaires de mémoires non volatiles (210, 310) simultanément à la première donnée et à la deuxième donnée ;
le composant de lecture (120) est connecté à au moins deux paires de mémoires non volatiles par l'intermédiaire d'au moins un élément sélecteur (220, 320) ; et que à la mise sous tension des circuits à bascule, le composant de lecture (120) est en outre configuré pour lire séquentiellement les données supplémentaires.

4. Une mémoire non-volatile multi-bits (30) comprenant :
un circuit de stockage non volatil (100) d'après la revendication 1 ou 2 ;
le premier circuit à bascule (32) et le deuxième circuit à bascule (34) connectés au composant de lecture (120) et au composant d'écriture (110) ;
sachant que :
à la mise hors tension de la mémoire non volatile multi-bits (30), le premier circuit à bascule (32) est configuré pour transmettre les premières données au composant d'écriture (110) et le deuxième circuit à bascule (34) est configuré pour transmettre les deuxièmes données au composant d'écriture (110) ; et que
à la mise sous tension de la mémoire non volatile multi-bits (30), le premier circuit à bascule (32) est configuré pour recevoir les premières données depuis le composant de lecture (120) et le deuxième circuit à bascule (34) est configuré pour recevoir les deuxièmes données depuis le composant de lecture (120).

5. La mémoire non volatile multi-bits (30) d'après la revendication 4, comprenant en outre au moins un tampon d'horloge, sachant que le au moins un tampon d'horloge est partagé entre le premier circuit à bascule (32) et le deuxième circuit à bascule (34).

6. Une mémoire non volatile multi-bits comprenant :
un circuit de stockage non volatil (200, 300, 400) d'après la revendication 3 ;
une pluralité de circuits à bascule connectés au composant de lecture (120) et au composant d'écriture (110), sachant que le nombre de circuits à bascule correspond au nombre total de paires de mémoires non volatiles ;
sachant que :
à la mise hors tension de la mémoire non volatile multi-bits, chaque circuit à bascule est configuré pour transmettre des données respectives au composant d'écriture (110) ; et que
à la mise sous tension de la mémoire non volatile multi-bits, chaque circuit à bascule est configuré pour recevoir les données respectives provenant du composant de lecture (120).

7. Un microprocesseur comprenant une ou plusieurs mémoires non volatiles multi-bits d'après l'une quelconque des revendications de 4 à 6.

8. Un procédé de fonctionnement d'un circuit de mémoire non volatile (100) pour stocker des premières données provenant d'un premier circuit à bascule (32) et des deuxièmes données provenant d'un deuxième circuit à bascule (34) lors d'un portillonnage de puissance (*power gating*), le circuit de stockage non volatil (100) comprenant :
un composant d'écriture (110) ;
deux nœuds de sortie ;
un composant de lecture (120) comprenant un composant de précharge (122) connecté aux deux nœuds de sortie ; et
une première paire de mémoires non volatiles (130) et une deuxième paire de mémoires non volatiles (140) connectées au composant de lecture (120) et au composant d'écriture (110) ;
le procédé comprenant le fait de :
à la mise hors tension du premier circuit à bascule (32) et du deuxième circuit à bascule (34), écrire simultanément, par le composant d'écriture (110), les premières données dans la première paire de mémoires non volatiles (130) et les deuxièmes données dans la deuxième paire de mémoires non volatiles (140) ; et
à la mise sous tension du premier circuit à bascule (32) et du deuxième circuit à bascule (34), lire de manière séquentielle, par le composant de lecture (120), les premières données provenant de la première paire de mémoires non volatiles (130) et les deuxièmes données provenant de la deuxième paire de mémoires non volatiles (140) ;
lors de la lecture des premières données provenant de la première paire de mémoires non volatiles (130) :
égaliser, par le composant de précharge (122), les deux noeuds de sortie à la tension d'alimentation ; et
connecter la première paire de mémoires non volatiles (130) à la terre ;
lors de la lecture des deuxièmes données provenant de la deuxième paire de mémoires non volatiles (140) :
égaliser, par le composant de précharge (122), des deux nœuds de sortie à la tension de terre ; et
connecter la deuxième paire de mémoires non volatiles (140) à une source de tension d'alimentation ;
et sachant que :
le composant de lecture (120) comprend un amplificateur de détection (*sense amplifier*) (124) incluant un premier inverseur et un deuxième inverseur, chaque inverseur comprenant deux transistors, sachant que chaque nœud de sortie est connecté à une sortie d'un inverseur correspondant ;
le composant de lecture (120) comprend en outre un premier élément de stabilisation (126) interposé entre l'amplificateur de détection (124) et la première paire de mémoires non volatiles (130), et un deuxième élément de stabilisation (128) interposé entre l'amplificateur de détection (124) et la deuxième paire de mémoires non volatiles (140) ;
le premier élément de stabilisation (126) est connecté aux bornes de source d'un premier transistor dans le premier inverseur et d'un premier transistor dans le deuxième inverseur, les premiers transistors étant chacun connecté à une mémoire correspondante des mémoires non volatiles de la première paire de mémoires non volatiles (130) ;
le deuxième élément de stabilisation (128) est connecté aux bornes de source d'un deuxième transistor dans le premier inverseur et d'un deuxième transistor dans le deuxième inverseur, les deuxièmes transistors étant chacun connecté à une mémoire correspondante des mémoires non volatiles de la deuxième paire de mémoires non volatiles (140) ; et que
le procédé comprend en outre le fait de :
égaliser, par le premier élément de stabilisation (126), les bornes de source des premiers transistors lors de la lecture des deuxièmes données ; et de égaliser, par le deuxième élément de stabilisation (128), les bornes de source des deuxièmes transistors lors de la lecture des premières données.

9. Le procédé d'après la revendication 8, comprenant en outre le fait de commander, par un signal commun, le composant de précharge (122) et les éléments de stabilisation premier et deuxième (126, 128).

10. Le procédé d'après la revendication 8 ou 9, sachant que le circuit de stockage non volatil (200, 300, 400) est en outre destiné à stocker des données supplémentaires provenant d'un ou plusieurs circuits à bascule supplémentaires, sachant que :
le circuit de stockage non volatil (200, 300, 400) comprend en outre une ou plusieurs paires supplémentaires de mémoires non volatiles (210, 310) et au moins un élément sélecteur (220, 320), le composant d'écriture (110) est connecté à la ou aux paires supplémentaires de mémoires non volatiles (210, 310) ;
le composant de lecture (120) est connecté à au moins deux paires de mémoires non volatiles via le au moins un élément sélecteur (220, 320) ; et que le procédé comprend en outre :
à la mise hors tension des circuits à bascule, écrire, par le composant d'écriture (110), les données supplémentaires dans la ou les paires supplémentaires de mémoires non volatiles (210, 310) simultanément aux premières données et aux deuxièmes données ; et
à la mise sous tension des circuits à bascule, lire, par le composant de lecture (120), les données supplémentaires de manière séquentielle avec les premières données et les deuxièmes données.

11. Le procédé d'après la revendication 8 ou 9, comprenant en outre le fait de :
à la mise hors tension du premier circuit à bascule (32) et du deuxième circuit à bascule (34) :
transmettre, par le premier circuit à bascule (32), les premières données au composant d'écriture (110) et
transmettre, par le deuxième circuit à bascule (34), les deuxièmes données au composant d'écriture (110) ; et de
à la mise sous tension du premier circuit à bascule (32) et du deuxième circuit à bascule (34) :
recevoir, par le premier circuit à bascule (32), les premières données provenant du composant de lecture (120) et
recevoir, par le deuxième circuit à bascule (34), les deuxièmes données provenant du composant de lecture (120).
